(19) Europäisches Patentamt
European Patent Office
Office européen des brevets

(11) EP 1 894 967 A1

(12) # EUROPEAN PATENT APPLICATION

published in accordance with Art. 153(4) EPC

(43) Date of publication:
**05.03.2008 Bulletin 2008/10**

(21) Application number: **06767059.6**

(22) Date of filing: **21.06.2006**

(51) Int Cl.:
***C08K 9/04*** *(2006.01)* ***C08L 101/00*** *(2006.01)*
***H05K 1/03*** *(2006.01)*

(86) International application number:
**PCT/JP2006/312400**

(87) International publication number:
**WO 2006/137432 (28.12.2006 Gazette 2006/52)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **21.06.2005 JP 2005181018**

(71) Applicant: **Nisshinbo Industries, Inc.**
**Chuo-ku,**
**Tokyo 103-8650 (JP)**

(72) Inventors:
- **TSUKAMOTO, Nami**
  **c/o NISSHINBO INDUSTRIES, INC.**
  **Chiba-shi,; Chiba 2670056 (JP)**
- **HASHIBA, Toshifumi**
  **c/o NISSHINBO INDUSTRIES, INC.**
  **Chiba-shi,; Chiba 2670056 (JP)**
- **MIZUSHIRI, Mayumi**
  **c/o NISSHINBO INDUSTRIES, INC.**
  **Chiba-shi,; Chiba 2670056 (JP)**

(74) Representative: **Stuart, Ian Alexander**
**Mewburn Ellis LLP**
**York House**
**23 Kingsway**
**London WC2B 6HP (GB)**

(54) **FILLER FOR SUBSTRATE AND COMPOSITION FOR USE AS MATERIAL FOR INORGANIC/ ORGANIC COMPOSITE SUBSTRATE FORMATION**

(57) A filler for substrates which comprises an inorganic substance and a carbodiimide-group-containing organic layer chemically bonded to the surface of the inorganic substance. Examples of the carbodiimide-group-containing organic layer include a layer comprising a carbodiimide-group-containing compound represented by either of the following formulae. Due to the constitution, the filler for substrates can be highly dispersed in a resin for substrates even when added in a high proportion and can give a substrate inhibited from deteriorating in electrical properties, mechanical properties, etc.

$$(X^1)_m\text{-}Z\text{-}[A\text{-}(R^1\text{-}N{=}C{=}N)_n\text{-}R^1\text{-}NCO]_1 \quad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_1 \quad (2)$$

[$R^1$ represents a residue of an isocyanate compound; $X^1$ and $X^2$ each independently represents hydrogen, halogeno, etc.; Z's each independently represents silicon or titanium; A represents an organic group having a valence of 2 or higher containing a bond derived from an isocyanate group; m and 1 each is an integer of 1-3, provided that m+1=4; and n is an integer of 1-100.]

EP 1 894 967 A1

## Description

### TECHNICAL FIELD

The present invention relates to a filler for substrates, and to a composition for use as an inorganic/organic composite substrate-forming material.

### BACKGROUND ART

In recent years, resins for electronic substrates have come to be subjected to high-temperature treatment using lead-free solder. At the same time, the miniaturization of electronic devices has led to a scaling down in the size of electronic substrates.
These developments have brought about a need for a higher heat resistance and a lower coefficient of thermal expansion in electronic substrate resins. Recently, it has been found that the coefficient of thermal expansion of a substrate-forming resin can be lowered by adding an inorganic substance to the resin. It has also been learned that the coefficient of thermal expansion of the resin fluctuates according to the amount of inorganic substance added (Patent Document 1: JP-A 5-230279).
When an inorganic substance is included in a resin or the like, it is very important to improve the affinity between the polymeric material and the inorganic substance. Many surface modification methods are carried out on inorganic substances for this purpose.
One of the most widely used surface modification methods is a process in which the surface of the inorganic substance is coated with an organic compound. In this process, the ability of the organic compound to adhere to the surface of the inorganic substance is important.
If the inorganic substance has a functional group, a strong coat can be formed by using a compound having a substituent capable of reacting with the functional group (e.g., a hydroxyl group), such as a silane coupling agent (see Patent Document 2: JP-A 61-275359; Patent Document 3: JP-A 63-258958).
However, when a high loading of the above-described inorganic substance that has been surface-treated is included in a substrate-forming resin so as to provide an even better coefficient of thermal expansion-lowering effect on the resin, this causes declines in the electrical characteristics, mechanical characteristics and thermal characteristics of shaped articles obtained therefrom.

1. Specific problems with electrical characteristics include the following three.

    (1) Because inorganic substances themselves have a high dielectric constant, the addition of a large amount of inorganic substance increases the dielectric constant of the shaped articles.
    (2) Inorganic substances have a poor dispersibility. Improving the dispersibility requires the addition of a dispersant such as colloidal silica, but such addition also increases the dielectric constant of the shaped articles.
    (3) The addition of an inorganic substance lowers the migration resistance.

2. Specific problems with mechanical characteristics include the following two.

    (1) When a large amount of an inorganic substance having a poor affinity with the resin is added, the shaped articles obtained therefrom are brittle.
    (2) Because inorganic substances have a poor dispersibility, it is difficult to achieve high loadings of inorganic substances in the resin.

3. Specific problems with thermal characteristics include the following.

    (1) Inorganic substances have a poor dispersibility. However, the addition of a dispersant or the use of an inorganic surface treatment agent to improve dispersibility lowers the thermal resistance.

Given such declines in the mechanical, electrical and other characteristics of shaped articles, there are limit to the amount of inorganic substance that may be loaded into a substrate-forming resin. This situation has made it impossible to adequately confer substrates with certain qualities achievable by adding an inorganic substance, such as a lower coefficient of thermal expansion.
Patent Document 1: JP-A 5-230279

Patent Document 2: JP-A 61-275359
Patent Document 3: JP-A 63-258958

DISCLOSURE OF THE INVENTION

Problems to be Solved by the Invention

It is therefore an object of the present invention to provide a filler for substrates which, even at high loadings in a substrate-forming resin, disperses well and is thus able to suppress declines in the electrical and mechanical properties of substrates obtained therefrom. Another object of the invention is to provide a composition for use as an inorganic/organic composite substrate-forming material, which composition includes such a filler and an organic resin.

Means for Solving the Problems

The inventors have conducted extensive investigations in order to achieve the above objects. As a result, they have discovered that substrate fillers which form a carbodiimide group-containing organic layer on the surface of an inorganic substance disperse well in substrate-forming resins, even at high loadings within the resin, and are able to suppress declines in the electrical characteristics (increased dielectric constant, decreased migration resistance), declines in the mechanical characteristics (embrittlement) and declines in the thermal characteristics of shaped articles (substrates) obtained therefrom.

Accordingly, the present invention provides the following fillers for substrates and the following compositions for use as inorganic/organic composite substrate-forming materials.

[1] A filler for substrates, characterized by comprising an inorganic substance and a carbodiimide group-containing organic layer that is chemically bonded to a surface of the inorganic substance.

[2] The substrate filler of [1] wherein, when tetrahydrofuran is used as a dispersing medium, the inorganic substance having said carbodiimide group-containing organic layer has a particle size distribution with a standard deviation ($A_2$) which satisfies the following relationship with respect to a standard deviation ($A_1$) of the particle size distribution for a surface-untreated inorganic substance:

$$(A_2)/(A_1) \leq 1.0.$$

[3] The substrate filler of [1] wherein, when tetrahydrofuran is used as a dispersing medium, the inorganic substance having said carbodiimide group-containing organic layer has a volume mean particle diameter ($M_2$) which satisfies the following relationship with respect to a volume mean particle diameter ($M_1$) of a surface-untreated inorganic substance:

$$(M_2)/(M_1) \leq 1.0.$$

[4] The substrate filler of [1] wherein, when pH 7 water is used as a dispersing medium, the inorganic substance having said carbodiimide group-containing organic layer has a particle size distribution with a standard deviation ($A_4$) which satisfies the following relationship with respect to a standard deviation ($A_3$) of the particle size distribution for a surface-untreated inorganic substance:

$$(A_4)/(A_3) > 1.0.$$

[5] The substrate filler of [1] wherein, when pH 7 water is used as a dispersing medium, the inorganic substance having said carbodiimide group-containing organic layer has a volume mean particle diameter ($M_4$) which satisfies the following relationship with respect to a volume mean particle diameter ($M_3$) of a surface-untreated inorganic substance:

$$(M_4)/(M_3) > 1.0.$$

[6] The substrate filler of [1], wherein said carbodiimide group-containing organic layer is at least one compound selected from among carbodiimide group-containing compounds of formula (1) below and carbodiimide group-containing compounds of formula (2) below:

$$(X^1)_m\text{-}Z\text{-}[A\text{-}(R^1\text{-}N{=}C{=}N)_n\text{-}R^1\text{-}NCO]_1 \qquad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_1 \qquad (2)$$

wherein
$R^1$ is a residue from an isocyanate compound;
$X^1$ and $X^2$ are each independently a hydrogen atom, a halogen atom, an alkyl group of 1 to 20 carbons which may include an unsaturated structure, an aryl group of 6 to 20 carbons, an aralkyl group of 7 to 20 carbons or an alkoxy group of 1 to 20 carbons, and $X^1$ and $X^2$ in each instance, if plural, may be the same or different;
each Z is independently a silicon atom or a titanium atom;
A is an organic group which has a valence of 2 or more and includes a bond derived from an isocyanate group;
the letters m and 1 are integers from 1 to 3 which satisfy the condition m+1 = 4; and
the letter n is an integer from 1 to 100.
[7] The substrate filler of [6], wherein at least one terminal isocyanate group on the carbodiimide group-containing compound of formula (1) is capped with a functional group which is reactive with isocyanate groups.
[8] The substrate filler of [7], wherein said functional group which is reactive with isocyanate groups is a hydroxyl group, a primary or secondary amino group, a carboxyl group or a thiol group.
[9] The substrate filler of any one of [1] to [8], wherein the carbodiimide group-containing organic layer is lipophilic.
[10] The substrate filler of any one of [1] to [9], wherein the inorganic substance is composed of particles having a volume mean particle diameter of from 1 nm to 100 μm.
[11] A composition for use as an inorganic/organic composite substrate-forming material which is characterized by comprising the substrate filler of any one of [1] to [10] and an organic resin.
[12] The composition for use as an inorganic/organic composite substrate-forming material of [11], wherein the substrate filler is included in an amount of at least 15 wt%, based on the organic resin.
[13] The composition for use as an inorganic/organic composite substrate-forming material of [11] or [12], wherein the substrate filler included in 1 g of the composition has a total surface area of at least 2,000 $cm^2$.

## BENEFITS OF THE INVENTION

Because the surface of the inorganic substance therein is covered with a carbodiimide group-containing organic layer, the substrate filler of the invention has a good affinity with and dispersibility in organic resins and organic solvents. Moreover, the organic resin and carbodiimide groups trigger chemical reactions, enabling the formation of strong bonds. Therefore, even when a large amount of this substrate filler is included in a substrate-forming resin, declines in the mechanical strength and in the electrical properties (e.g., migration resistance) of shaped articles (substrates) obtained from the resulting composition can be suppressed.
Furthermore, because the substrate filler of the invention has an excellent dispersibility in organic resins, there is no need for the concomitant use of a dispersant, making it possible to prevent the rise in dielectric constant and the decrease in heat resistance associated with the use of dispersants that have been observed in prior-art products.
Hence, by using the substrate filler of the invention, declines in the physical, electrical and thermal characteristics of the resulting shaped articles (substrates) can be suppressed even when the amount of such addition is increased. Consequently, such shaped articles (substrates) can be effectively imparted with various advantageous effects of inorganic substance addition, such as a decrease in the coefficient of thermal expansion.

## BEST MODE FOR CARRYING OUT THE INVENTION

The invention is described more fully below.

The substrate filler of the invention is composed of an inorganic substance and a carbodiimide group-containing organic layer that is chemically bonded to a surface of the inorganic substance.

Illustrative, non-limiting, examples of the inorganic substance in the invention include metals such as gold, silver, copper, iron and cobalt; alkaline earth metal carbonates such as calcium carbonate, barium carbonate and magnesium carbonate; alkaline earth metal silicates such as calcium silicate, barium silicate and magnesium silicate; alkaline earth metal phosphates such as calcium phosphate, barium phosphate and magnesium phosphate; alkaline earth metal sulfates such as calcium sulfate, barium sulfate and magnesium sulfate; metal oxides such as silicon oxide (silica), magnesium oxide, aluminum oxide, zinc oxide, iron oxide, titanium oxide, cobalt oxide, nickel oxide, manganese oxide, antimony oxide, tin oxide, calcium oxide, potassium oxide, silicon oxide and chromium oxide; metal hydroxides such as iron hydroxide, nickel hydroxide, aluminum hydroxide, magnesium hydroxide, calcium hydroxide, chromium hydroxide, potassium hydroxide and zinc hydroxide; metal nitrides such as silicon nitride, aluminum nitride and boron nitride; metal silicates such as zinc silicate, aluminum silicate and copper silicate; metal carbonates such as zinc carbonate, aluminum carbonate, cobalt carbonate, nickel carbonate and basic copper carbonate; and glasses or magnetic materials made thereof. These may be used singly or as combinations of two or more thereof.

Of the above, to impart the suitable functionality that is required in substrates obtained from compositions prepared by compounding the substrate filler of the invention with an organic resin, it is preferable to use an inorganic oxide or hydroxide such as silicon oxide (silica), magnesium hydroxide, aluminum hydroxide, calcium hydroxide, potassium hydroxide, zinc hydroxide, magnesium oxide, aluminum oxide, zinc oxide, iron oxide, titanium oxide, cobalt oxide, nickel oxide, manganese oxide, calcium oxide and potassium oxide; a metal nitride such as silicon nitride, aluminum nitride and boron nitride; or a glass. Silicon oxide, which is commonly added to lower the coefficient of thermal expansion in substrates, is especially preferred.

From the standpoint of such considerations as the dispersibility of the substrate filler in organic resins and the moldability of compositions made of the substrate filler and an organic resin, it is preferable for the inorganic substance to be in the form of particles having a volume mean particle diameter of from 1 nm to 100 μm, preferably from 10 nm to 50 μm, and more preferably from 20 nm to 30 μm.

The carbodiimide group-containing organic layer in the invention is composed of a carbodiimide group-containing compound.

No limitation is imposed on the carbodiimide group-containing compound, provided the compound contains a carbodiimide group. For example, use may be made of a compound of formula (I) below.

$$OCN\text{-}(R^1\text{-}N{=}C{=}N)_n\text{-}R^1\text{-}NCO \qquad (I)$$

In formula (I), $R^1$ is a residue from an isocyanate compound, and the letter n is an integer from 1 to 100.

Carbodiimide group-containing compounds of above formula (I) (referred to below as simply "carbodiimide compounds") can be obtained in the presence of a catalyst which promotes the conversion of isocyanate groups on an organic polyisocyanate compound to carbodiimide groups. Illustrative examples include carbodiimide compounds which can be prepared by the method disclosed in JP-A 51-61599, the method of L.M. Alberino et al. (J. Appl. Polym. Sci., 21, 190 (1990)), or the method disclosed in JP-A 2-292316.

The carbodiimide compound of formula (I) has a weight-average molecular weight of generally about 200 to about 100,000. From the standpoint of dispersibility in organic resins and organic solvents, a weight-average molecular weight of from 500 to 50,000 is preferred.

Illustrative examples of organic isocyanate compounds which may be used to prepare the carbodiimide compound include 4,4'-dicyclohexylmethane diisocyanate, m-tetramethylxylylene diisocyanate, 2,4-tolylene diisocyanate, 2,6-tolylene diisocyanate, mixtures of 2,4-tolylene diisocyanate and 2,6-tolylene diisocyanate, crude tolylene diisocyanate, crude methylenediphenyl diisocyanate, 4,4',4"-triphenylmethylene triisocyanate, xylene diisocyanate, hexamethylene-1,6-diisocyanate, lysine diisocyanate, hydrogenated methylenediphenyl diisocyanate, m-phenyl diisocyanate, naphthylene-1,5-diisocyanate, 4,4'-biphenylene diisocyanate, 4,4'-diphenylmethane diisocyanate, 3,3'-dimethoxy-4,4'-biphenyl diisocyanate, 3,3'-dimethyldiphenylmethane-4,4'-diisocyanate and isophorone diisocyanate. These may be used singly or as mixtures of two or more thereof. Of these, for reasons having to do with the reactivity and the dispersibility in resins for electronic materials, 4,4'-diphenylmethane diisocyanate, 2,4-tolylene diisocyanate, hexamethylene-1,6-diisocyanate, m-tetramethylxylylene diisocyanate and 4,4'-dicyclohexylmethane diisocyanate are preferred.

Polycondensation arises via the conversion of isocyanate groups in the foregoing organic isocyanate compounds to carbodiimide. This reaction is typically carried out by heating the organic isocyanate compound in the presence of a carbodiimidation catalyst. At this time, the molecular weight (degree of polymerization) of the carbodiimide compound obtained can be adjusted by adding at an appropriate stage, as an end-capping agent, a compound having a functional group capable of reacting with the isocyanate group, such as a hydroxyl group, a primary or secondary amino group, a carboxyl group or a thiol group, and thereby capping the ends of the carbodiimide compound. The degree of polymerization can also be adjusted by means of such parameters as the concentration of the isocyanate compound and the reaction time.

Any of various carbodiimidation catalysts may be used, although the use of, for example,
1-phenyl-2-phospholene-1-oxide,
3-methyl-1-phenyl-2-phospholene-1-oxide,
1-ethyl-2-phospholene-1-oxide and
3-phospholene isomers thereof is preferred from the standpoint of product yield and other considerations.

The above reaction may be carried out either in the presence or absence of a catalyst. It is also possible to add a solvent at the time of the reaction.

The solvent, so long as it does not exert an influence on the isocyanate groups and the carbodiimide groups at the time of the reaction, is not subject to any particular limitation. The solvent may be suitably selected in accordance with the method of polymerization.

Specific examples of solvents that may be used include ketones such as acetone, methyl ethyl ketone, methyl isobutyl ketone and cyclohexanone; esters such as ethyl acetate, butyl acetate, ethyl propionate and cellosolve acetate; aliphatic or aromatic hydrocarbons such as pentane, 2-methylbutane, n-hexane, cyclohexane, 2-methylpentane, 2,2-dimethylbutane, 2,3-dimethylbutane, heptane, n-octane, isooctane, 2,2,3-trimethylpentane, decane, nonane, cyclopentane, methylcyclopentane, methylcyclohexane, ethylcyclohexane, p-menthane, benzene, toluene, xylene and ethylbenzene; halogenated hydrocarbons such as carbon tetrachloride, trichloroethylene, chlorobenzene and tetrabromoethane; ethers such as ethyl ether, dimethyl ether, trioxane and tetrahydrofuran; acetals such as methylal and diethylacetal; and sulfur or nitrogen-containing organic compounds such as nitropropene, nitrobenzene, pyridine, dimethylformamide and dimethylsulfoxide. These may be used singly or as combinations of two or more thereof.

Moreover, in cases where the ends of the carbodiimide compound are capped with, for example, the subsequently described end-capping segments and thereby rendered hydrophilic, diluents that may be used include, in addition to the above-mentioned solvents: water; alcohols such as methanol, ethanol, 1-propanol, 2-propanol, 1-butanol, 2-butanol, isobutyl alcohol, tert-butyl alcohol, 1-pentanol, 2-pentanol, 3-pentanol, 2-methyl-1-butanol, isopentyl alcohol, tert-pentyl alcohol, 1-hexanol, 2-methyl-1-pentanol, 4-methyl-2-pentanol, 2-ethylbutanol, 1-heptanol, 2-heptanol, 3-heptanol, 2-octanol, 2-ethyl-l-hexanol, benzyl alcohol and cyclohexanol; ether alcohols such as methyl cellosolve, ethyl cellosolve, isopropyl cellosolve, butyl cellosolve and diethylene glycol monobutyl ether. These may be used singly or as combinations of two or more thereof. Because carbodiimide groups have a high reactivity, it is preferable to carry out dilution at a relatively low temperature.

In the substrate filler of the invention, a compound of formula (1) or (2) below may be used as the carbodiimide group-containing compound. With the use of these compounds, a carbodiimide group-containing organic layer can be efficiently formed on the surface of the inorganic substance, which is especially preferred.

$$(X^1)_m\text{-}Z\text{-}[A\text{-}(R^1\text{-}N{=}C{=}N)_n\text{-}R^1\text{-}NCO]_l \qquad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_l \qquad (2)$$

In above formulas (1) and (2), $R^1$ is a residue from an isocyanate compound. "A residue from an isocyanate compound" refers herein to the partial structure which results from the removal of the isocyanate groups from an organic isocyanate compound and which remains in the carbodiimide compound when a (poly)carbodiimide compound is prepared from the isocyanate compound.

$X^1$ and $X^2$ are each independently a hydrogen atom, a halogen atom, an alkyl group of 1 to 20 carbons which may include an unsaturated structure, an aryl group of 6 to 20 carbons, an aralkyl group of 7 to 20 carbons, or an alkoxy group of 1 to 20 carbons. If there are a plurality of $X^1$ moieties, each instance of $X^1$ may be the same or different. Likewise, if there are a plurality of $X^2$ moieties, each instance of $X^2$ may be the same or different.

The halogen atom may be a fluorine, chlorine, bromine or iodine atom.

The alkyl group of 1 to 20 carbons which may include an unsaturated structure may have a linear, branched or cyclic structure. Illustrative examples include methyl, ethyl, n-propyl, n-butyl, isopropyl, isobutyl, sec-butyl, tert-butyl, cyclopropyl, cyclobutyl, cyclopentyl, methylcyclopentyl and cyclohexyl groups.

Examples of aryl groups of 6 to 20 carbons include phenyl, tolyl and biphenyl groups.

The aralkyl group of 7 to 20 carbons is exemplified by a benzyl group.

Examples of alkoxy groups of 1 to 20 carbons include methoxy, ethoxy, n-butoxy, t-butoxy and phenoxy groups. The alkyl moiety in the alkoxy group may have a linear, branched or cyclic structure.

The letter A represents an organic group with a valence of 2 or more that includes a bond derived from an isocyanate group.

"A bond derived from an isocyanate group" refers herein to a bond which forms from the reaction of an isocyanate group with a functional group capable of reacting with the isocyanate group.
Illustrative, non-limiting, examples of functional groups capable of reacting with the isocyanate group include hydroxyl groups, primary or secondary amino groups, carboxyl groups and thiol groups.
The bond which forms from the reaction of these functional groups with an isocyanate group is exemplified by urethane bonds, thiourethane bonds, urea bonds, amide bonds, carbodiimide bonds, allophanate bonds, biuret bonds, acylurea bonds, urethane-imine bonds, isocyanate dimerization bonds and isocyanate trimerization bonds. Of these, at least one type selected from among urea bonds, urethane bonds, thiourethane bonds and amide bonds is preferred because the reaction can easily be carried out at a relatively low temperature to form the bond.
The letter A may additionally include linkages between the isocyanate group-derived bond and Z. Illustrative, non-limiting, examples of such linkages include $-(CH_2)_k-$, $-(CH_2)_k-NH-(CH_2)_k-$, $-CO-NH-(CH_2)_k-$ (the letter k above representing an integer from 1 to 20), -CO-O- and -O-.

The letter m in $(X^1)_m$ above is an integer from 1 to 3, although it is preferable for m to be 3 (particularly in the case of formula (1) compounds).
If there are a plurality of $X^1$ moieties, taking into account the reactivity of the compounds of formulas (1) and (2) with the inorganic substance surface, it is preferable for at least one $X^1$ moiety to be an alkoxy group of 1 to 20 carbons, and preferably 1 to 5 carbons, and most preferable for all the $X^1$ moieties to be alkoxy groups of 1 to 5 carbons.
With regard to the $X^2$ moieties, for the same reason, it is preferable for at least one $X^2$ moiety to be an alkoxy group of 1 to 20 carbons, and preferably 1 to 5 carbons, and most preferable for all the $X^2$ moieties to be alkoxy groups of 1 to 5 carbons.
Preferred examples of alkoxy groups having 1 to 5 carbons include methoxy and ethoxy groups.
The letters m and 1 are integers from 1 to 3 which satisfy the condition m+1 = 4, although it is preferable, in keeping with the preferred value of m noted above, for the letter 1 to be 1 (particularly in the case of formula (1) compounds).

Each Z is independently a silicon atom or a titanium atom. Here, in above formula (1), $(X)_m$-Z- is preferably a site capable of functioning as a coupling agent. In above formula (2), at least one of $(X^1)_m$-Z- and $-Z-(X^2)_3$ is preferably a site capable of functioning as a coupling agent.
Taking these points into account, it is preferable for the Z moiety in formula (1) and for the two Z moieties in formula (2) to be silicon atoms. The above formulas (1) and (2) in such a case are represented by formulas (1') and (2') below.

$$(X^1)_m-Si-[A-(R^1-N=C=N)_n-R^1-NCO]_l \qquad (1')$$

$$(X^1)_m-Si-[A-(R^1-N=C=N)_n-R^1-A-Si-(X^2)_3]_l \qquad (2')$$

In the above formulas, $X^1$, $X^2$, A, $R^1$, l, m and n are as described above.

The compound represented by above formula (1) or (2) has a weight-average molecular weight of preferably from 300 to 100,000, more preferably from 500 to 50,000, even more preferably from 600 to 40,000, and most preferably from 1,000 to 20,000. At a weight-average molecular weight of more than 100,000, steric hindrance becomes substantial, possibly resulting in a loss of the surface treatment effect (i.e., efficient surface modification of the inorganic substance) by the compound.
The letter n above is an integer from 1 to 100. However, taking into account the fact that, as noted above, a rise in the weight-average molecular weight leads to an increase in steric hindrance, which may lower the surface treatment effect, it is preferable for the letter n to be from 2 to 80.

The carbodiimide group-containing compound of above formula (1) or (2) may be obtained by, for example, at any stage in the preparation of the compound of above formula (I), reacting a silicon or titanium atom-containing coupling agent having a functional group or bonding group capable of reacting with an isocyanate group on the carbodiimide compound.
In this coupling agent, the functional group or bonding group which is reactive with an isocyanate group is not subject to any particular limitation provided it is a group capable of reacting with an isocyanate group. Illustrative examples include hydroxyl groups, amino groups (preferably primary or secondary), carboxyl groups, thiol groups, isocyanate groups, epoxy groups, urethane bonds, urea bonds, amide bonds and acid anhydride groups. Of these, widely available amino groups (preferably primary or secondary), thiol groups, isocyanate groups and epoxy groups are preferred.

Specific examples of silane coupling agents include the following.
Examples of amino group-containing silane coupling agents include γ-aminopropyltrimethoxysilane,
γ-aminopropyltriethoxysilane,

γ-aminopropylmethyldimethoxysilane,
γ-aminopropyldimethylmethoxysilane,
γ-aminopropylmethyldiethoxysilane,
γ-aminopropyldimethylethoxysilane,
N-phenyl-γ-aminopropyltrimethoxysilane,
N-phenyl-γ-aminopropyltriethoxysilane,
N-β-(aminoethyl)-γ-aminopropyltrimethoxysilane,
N-β-(aminoethyl)-γ-aminopropyltriethoxysilane,
N-β-(aminoethyl)-γ-aminopropylmethyldimethoxysilane and
N-β-(aminoethyl)-γ-aminopropylmethyldimethyldiethoxysilane.

Examples of thiol group-containing silane coupling agents include 3-mercaptopropyltrimethoxysilane, 3-mercaptopropyltriethoxysilane, mercaptomethyldimethylethoxysilane, (mercaptomethyl)methyldiethoxysilane and 3-mercaptopropylmethyldimethoxysilane.

Examples of isocyanate group-containing silane coupling agents include γ-isocyanatopropyltrimethoxysilane,
γ-isocyanatopropyltriethoxysilane,
γ-isocyanatopropylmethyldimethoxysilane,
γ-isocyanatopropyldimethylmethoxysilane,
γ-isocyanatopropylmethyldiethoxysilane and γ-isocyanatopropyldimethylethoxysilane.

Examples of epoxy group-containing silane coupling agents include γ-glycidoxypropyltrimethoxysilane,
γ-glycidoxypropyltriethoxysilane,
γ-glycidoxypropylmethyldimethoxysilane,
γ-glycidoxypropyldimethylmethoxysilane,
γ-glycidoxypropylmethyldiethoxysilane,
γ-glycidoxypropyldimethylethoxysilane,
γ-glycidoxypropylethyldimethoxysilane,
γ-glycidoxypropyldiethylmethoxysilane,
γ-glycidoxypropylethyldiethoxysilane,
γ-glycidoxypropyldiethylethoxysilane,
β-(3,4-epoxycyclohexyl)ethyltrimethoxysilane,
β-(3,4-epoxycyclohexyl)ethyltriethoxysilane,
β-(3,4-epoxycyclohexyl)ethylmethyldimethoxysilane,
β-(3,4-epoxycyclohexyl)ethyldimethylmethoxysilane,
β-(3,4-epoxycyclohexyl)ethylmethyldiethoxysilane,
β-(3,4-epoxycyclohexyl)ethyldimethylethoxysilane,
β-(3,4-epoxycyclohexyl)ethylethyldimethoxysilane,
β-(3,4-epoxycyclohexyl)ethyldiethylmethoxysilane,
β-(3,4-epoxycyclohexyl)ethylethyldiethoxysilane,
β-(3,4-epoxycyclohexyl)ethyldiethylethoxysilane, 3-epoxypropyltrimethoxysilane, 3-epoxypropyltriethoxysilane, 3-epoxypropylmethyldimethoxysilane,
3-epoxypropyldimethylmethoxysilane,
3-epoxypropylmethyldiethoxysilane,
3-epoxypropyldimethylethoxysilane,
3-epoxypropylethyldimethoxysilane,
3-epoxypropyldiethylmethoxysilane,
3-epoxypropylethyldiethoxysilane,
3-epoxypropyldiethylethoxysilane, 4-epoxybutyryltrimethoxysilane, 6-epoxyhexyltrimethoxysilane, 8-epoxyoctyltrimethoxysilane, 4-epoxybutyryltriethoxysilane, 6-epoxyhexyltriethoxysilane and 8-epoxyoctyltriethoxysilane.

Titanate coupling agents are exemplified by titanium acylates, titanium acylate polymers, titanium phosphate polymers and titanium alcoholates.

The above coupling agents may be used singly or as combinations of two or more thereof.

Of the above coupling agents, for such reasons as good water resistance, adherence to the inorganic substance, hardness of the applied coat, staining properties and pot life, the use of the following coupling agents are preferred:

γ-glycidoxypropyltrimethoxysilane,

γ-glycidoxypropylmethyldiethoxysilane,

γ-glycidoxypropyltriethoxysilane,

β-(3,4-epoxycyclohexyl)ethyltrimethoxysilane,

β-(3,4-epoxycyclohexyl)ethyltriethoxysilane,

γ-aminopropyltrimethoxysilane, γ-aminopropyltriethoxysilane,

N-β-(aminoethyl)-γ-aminopropyltrimethoxysilane,

N-β-(aminoethyl)-γ-aminopropyltriethoxysilane,

γ-isocyanatopropyltrimethoxysilane and

γ-isocyanatopropyltriethoxysilane.

The temperature of the reaction between the isocyanate group and the above coupling agent is generally in a range of from about -50 to about +200°C. However, to suppress reactions between the carbodiimide group and the coupling agent, a relatively low temperature in a range of from -30 to about +100°C, and especially from about -10 to about +50°C, is preferred.
The carbodiimide group and the coupling agent may be allowed to react, insofar as the performance of the carbodiimide group-containing organic layer is not thereby compromised.
In the carbodiimide compounds of above-described formulas (I), (1) and (2), the number of carbodiimide groups on the molecule is, on average, preferably from about 1 to about 100, and more preferably from 2 to 80. If the number of carbodiimide groups is less than 1, the compound may not exhibit to a sufficient degree the properties of a carbodiimide compound. On the other hand, if the number of carbodiimide groups is more than 100, synthesis will be possible but the compound will have a high molecular weight and may thus be difficult to handle.
The carbodiimide group-containing compound used in the substrate filler of the invention may be a (co)polymer which has at least one type of recurring unit from among those of formulas (3) and (4) below and which also has, if necessary, recurring units of formula (5) below. By having the compound be such a (co)polymer, the carbodiimide groups can be efficiently included within various types of polymer.
[Chemical Formula 1]

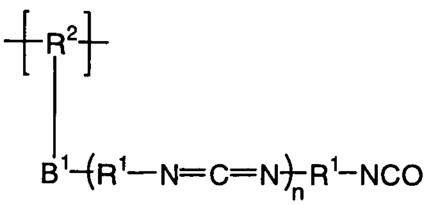

(3)

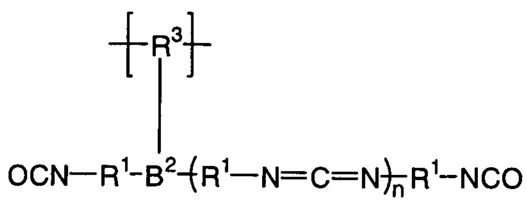

(4)

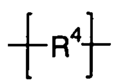

(5)

In the above formulas, $R^2$ is a monomer-derived partial structure having both a group capable of reacting with an isocyanate group and a polymerizable functional group, and $B^1$ is a bonding group which is formed by the reaction of a isocyanate group with a group capable of reacting with the isocyanate group. $R^3$ is a monomer-derived partial structure having both a group capable of reacting with a carbodiimide group and a polymerizable functional group, and $B^2$ is a bonding group which is formed by the reaction of a carbodiimide group with a group capable of reacting with the carbodiimide group. $R^4$ is a monomer-derived partial structure which has a polymerizable functional group but lacks a functional group capable of reacting with an isocyanate group or a carbodiimide group. $R^1$ and the letter n are the same as mentioned above.
$R^2$is a partial structure which can be obtained by the reaction of a monomer having both a group capable of reacting with an isocyanate group and a polymerizable functional group with an isocyanate group, and also by polymerization using the polymerizable functional groups. $R^2$ forms the main chain on a (co)polymer. The functional group capable of reacting with an isocyanate group is exemplified by hydroxyl groups, primary or secondary amino groups, carboxyl groups and thiol groups.

$R^3$ is a partial structure which can be obtained by the reaction of a monomer having both a group capable of reacting with a carbodiimide group and a polymerizable functional group with a carbodiimide group, and polymerization using the polymerizable functional groups. $R^3$ forms the main chain on a (co)polymer. The functional group capable of reacting with a carbodiimide group is exemplified by hydroxyl groups, amino groups (preferably primary or secondary), carboxyl groups, thiol groups, isocyanate groups, epoxy groups, urethane bonds, urea bonds, amide bonds and acid anhydride. The polymerizable functional groups in $R^2$, $R^3$ and $R^4$ are not subject to any particular limitation. However, based on such considerations as polymerizability and the simplicity of the reaction operations, it is preferable for these groups to be polymerizable double bonds.

Specific examples of monomers having a group capable of reacting with an isocyanate group or a carbodiimide group and having also a polymerizable functional group include 2-hydroxyethyl acrylate, 2-hydroxyethyl methacrylate, 2-hydroxylpropyl acrylate, 2-hydroxylpropyl methacrylate, pentaerythritol triacrylate, pentaerythritol trimethacrylate, glycidyl acrylate, glycidyl methacrylate, allyl alcohol, 3-buten-1-ol, 4-penten-1-ol, allylamine, N-methylallylamine, N-ethyl-2-methylallylamine, diallylamine, allylcyclohexylamine, butadiene monoxide, 1,2-epoxy-5-hexene, 1,2-epoxy-7-octene, allyl glycidyl ether, 2-allylphenol, 2-allyloxyethanol, pentaerythritol triallyl ether, polyethylene glycol monomethacrylate, polypropylene glycol monomethacrylate, polyethylene glycol monoacrylate, 2-sulfoethyl methacrylate, polyethylene glycol monoarylate, 2-hydroxy-1,3-dimethacryloxypropane and polypropylene glycol monoacrylate. These may be used singly or as combinations of two or more thereof.

$R^4$ is a partial structure which can be obtained by using the polymerizable functional group on a monomer having both a polymerizable functional group and a functional group capable of reacting with an isocyanate group and a carbodiimide group to polymerize the monomer. $R^4$ forms the main chain on a (co)polymer. This monomer is an optional ingredient that may be used as needed.

Illustrative examples of such monomers having a polymerizable functional group and a functional group capable of reacting with an isocyanate group and a carbodiimide group include olefins such as ethylene and propylene; styrene compounds such as styrene, o-methylstyrene, m-methylstyrene, p-methylstyrene, $\alpha$-methylstyrene, p-ethylstyrene, 2,4-dimethylstyrene, p-n-butylstyrene, p-t-butylstyrene, p-n-hexyl styrene, p-n-octylstyrene, p-n-nonylstyrene, p-n-decylstyrene, p-n-dodecylstyrene, p-methoxystyrene, p-phenylstyrene, p-chlorostyrene and 3,4-dichlorostyrene; (meth)acrylic acid derivatives such as methyl acrylate, ethyl acrylate, n-butyl acrylate, isobutyl acrylate, propyl acrylate, hexyl acrylate, 2-ethylhexyl acrylate, n-octyl acrylate, dodecyl acrylate, lauryl acrylate, stearyl acrylate, 2-chloroethyl acrylate, phenyl acrylate, methyl $\alpha$-chloroacrylate, methyl methacrylate, ethyl methacrylate, n-butyl methacrylate, isobutyl methacrylate, propyl methacrylate, hexyl methacrylate, 2-ethylhexyl methacrylate, n-octyl methacrylate, dodecyl methacrylate, lauryl methacrylate, stearyl methacrylate, (meth)acrylonitrile, (meth)acrylate and methyl (meth)acrylate; vinyl ethers such as vinyl methyl ether, vinyl ethyl ether and vinyl isobutyl ether; vinyl ketones such as vinyl methyl ketone, vinyl hexyl ketone and methyl isopropenyl ketone; N-vinyl compounds such as N-vinylpyrrole, N-vinylcarbazole, N-vinylindole and N-vinylpyrrolidone; fluorinated alkyl group-containing compounds such as vinyl fluoride, vinylidene fluoride, tetrafluoroethylene, hexafluoropropylene, trifluoroethyl acrylate and tetrafluoropropyl acrylate; and halogenated organic compounds such as ethyl bromide, (S)-3-bromo-3-methylhexane and chloromethane. These may be used singly or as combinations of two or more thereof. Of these, based on such considerations as versatility and reactivity, the use of styrene compounds and (meth)acrylic acid derivatives is preferred. Styrene and methyl methacrylate are especially preferred.

In the (co)polymer which has at least one type of recurring unit of above formulas (3) and (4) and which also has, if necessary, recurring units of above formula (5), the number of carbodiimide groups present on the molecule is, on average, preferably from about 1 to about 100, and more preferably from 2 to 80. If the number of carbodiimide groups is less than 1, the compound may not exhibit to a sufficient degree the properties of a carbodiimide group-containing compound. On the other hand, if the number of carbodiimide groups is more than 100, synthesis will be possible but the compound will have a high molecular weight and may thus be difficult to handle.

The above (co)polymer has a weight-average molecular weight of preferably from 1,000 to 1,000,000, more preferably from 2,500 to 950,000, even more preferably from 5,000 to 500,000, and most preferably from 10,000 to 300,000.

The agglomerating properties of the substrate filler and its dispersibility in organic resins may be controlled by, for example, changing the composition of the various above-described carbodiimide group-containing compounds, adjusting their molecular weights, or modifying the end-capping segments (in the case of compounds of formulas (I), (1), (3) and (4)). All of the isocyanate groups on the carbodiimide group-containing compound may be capped, although it is also possible to allow an isocyanate group to remain at one or both ends.

Illustrative examples of ordinary compounds which are capable of serving as capping agents; i.e., which react with isocyanate groups, are given below.

(a) Hydroxyl (OH) Group-Bearing Compounds

Examples of hydroxyl group-bearing compounds include

(i) primary alcohols such as methanol, ethanol, 1-propanol, 2-propanol, n-butanol, sec-butanol, tert-butanol, n-octanol and n-dodecyl alcohol;
(ii) saturated or unsaturated glycols such as ethylene glycol, propylene glycol, trimethylolpropane, pentaerythritol, 1,2-propanediol, 1,3-propanediol, 1,3-butanediol, 1,4-butanediol, neopentyl glycol, pentanediol, hexanediol, octanediol, 1,4-butenediol, diethylene glycol, triethylene glycol and dipropylene glycol;
(iii) cellosolves such as methyl cellosolve, ethyl cellosolve and butyl cellosolve;
(iv) (meth)acrylic monomers such as 2-hydroxyethyl (meth)acrylate, 2-hydroxypropyl (meth)acrylate, 3-hydroxypropyl (meth)acrylate and 4-hydroxybutyl (meth)acrylate;
(v) polyalkylene glycol (meth)acrylic compounds such as polyethylene glycol mono(meth)acrylate and polypropylene glycol mono(meth)acrylate;
(vi) various hydroxyalkyl vinyl ethers such as hydroxyethyl vinyl ether and hydroxybutyl vinyl ether;
(vii) various allyl compounds such as allyl alcohol and 2-hydroxyethyl allyl ether;
(viii) alkyl glycidyl ethers such as n-butyl glycidyl ether and 2-ethylhexyl glycidyl ether; and
(ix) hydroxyl group-containing polymers such as polyethylene glycol and polypropylene glycol. These may be used singly or as combinations of two or more thereof.

(b) Mercapto Group-Bearing Compounds:
Examples of mercapto group-bearing compounds include

(i) aliphatic alkyl monofunctional thiols such as methanethiol, ethanethiol, n- or isopropanethiol, n- or iso-butanethiol, pentanethiol, hexanethiol, heptanethiol, octanethiol, nonanethiol, decanethiol and cyclohexanethiol;
(ii) aliphatic thiols having a heterocycle, such as 1,4-dithian-2-thiol, 2-(1-mercaptomethyl)-1,4-dithian, 2-(1-mercaptoethyl)-1,4-dithian, 2-(1-mercaptopropyl)-1,4-dithian, 2-(mercaptobutyl)-1,4-dithian, tetrahydrothiophen-2-thiol, tetrahydrothiophen-3-thiol, pyrrolidin-2-thiol, pyrrolidin-3-thiol, tetrahydrofuran-2-thiol, tetrahydrofuran-3-thiol, piperidin-2-thiol, piperidin-3-thiol and piperidin-4-thiol;
(iii) aliphatic thiols having a hydroxyl group, such as 2-mercaptoethanol, 3-mercaptopropanol and thioglycerol;
(iv) compounds having an unsaturated double bond, such as 2-mercaptoethyl (meth)acrylate, 2-mercapto-1-carboxyethyl (meth)acrylate, N-(2-mercaptoethyl)acrylamide, N-(2-mercapto-l-carboxyethyl)acrylamide, N-(2-mercaptoethyl)methacrylamide, N-(4-mercaptophenyl)acrylamide, N-(7-mercaptonaphthyl)acrylamide and mono(2-mercaptoethylamide) maleate;
(v) aliphatic dithiols such as 1,2-ethanedithiol, 1,3-propanedithiol, 1,4-butanedithiol, 1,6-hexanedithiol, 1,8-octanedithiol, 1,2-cyclohexanedithiol, ethylene glycol bisthioglycolate, ethylene glycol bisthiopropionate, butanediol bisthioglycolate, butanediol bisthiopropionate, trimethylolpropane tristhioglycolate, trimethylolpropane tristhiopropionate, pentaerythritol tetrakisthioglycolate, pentaerythritol tetrakisthiopropionate, tris(2-mercaptoethyl)isocyanurate and tris(3-mercaptopropyl)isocyanurate;
(vi) aromatic dithiols such as 1,2-benzenedithiol, 1,4-benzenedithiol, 4-methyl-1,2-benzenedithiol, 4-butyl-1,2-benzenedithiol and 4-chloro-1,2-benzenedithiol; and
(vii) mercapto group-bearing polymers such as mercapto group-bearing modified polyvinyl alcohols. These may be used singly or as combinations of two or more thereof.

(c) Amino Group-Bearing Compounds:
Examples of amino group-bearing compounds include

(i) aromatic amino group-bearing compounds such as ammonia, methylamine, ethylamine, n-propylamine, isopropylamine, monoethanolamine, n-propanolamine, isopropanolamine, aniline, cyclohexylamine, n-butylamine, n-pentylamine, n-hexylamine, n-heptylamine, n-octylamine, n-nonylamine, n-decylamine, n-undecylamine, n-dodecylamine, n-tridecylamine, n-tetradecylamine, n-pentadecylamine, cyclohexylamine, n-hexadecylamine, n-heptadecylamine, n-octadecylamine, n-eicosylamine, diethylamine, diethanolamine, dibutylamine, di-n-propanolamine, diisopropanolamine, N-methylethanolamine and N-ethylethanolamine;
(ii) alkylamino acrylates such as dimethylaminoethyl acrylate, diethylaminoethyl acrylate, dimethylaminomethyl acrylate, diethylaminomethyl acrylate, addition products of diacrylate and diethylamine, and addition products of trimethylolpropane triacrylate and diethylamine;
(iii) alkylaminoalkyl vinyl ethers such as (meth)acrylamide, $\alpha$-ethyl (meth)acrylamide, N-methyl (meth)acrylamide, N-butoxymethyl (meth)acrylamide, diacetone (meth)acrylamide, N,N-dimethyl (meth)acrylamide, N,N-diethyl (meth)acrylamide, N,N-dimethyl p-styrenesulfonamide, N,N-dimethylaminoethyl (meth)acrylate, N,N-diethylaminoethyl (meth)acrylate, N,N-dimethylaminopropyl (meth)acrylate, N,N-diethylaminopropyl (meth)acrylate, N-[2-(meth)acryloyloxyethyl]piperidine, N-[2-(meth)acryloyloxyethylene]pyrrolidine, N-[2-(meth)acryloyloxyethyl]morpholine, 4-(N,N-dimethylamino)styrene, 4-(N,N-diethylamino)styrene, 4-vinylpyridine, 2-dimethylaminoethyl vinyl ether, 2-diethylaminoethyl vinyl ether, 4-dimethylaminobutyl vinyl ether, 4-diethylaminobutyl vinyl ether and 6-dimethylaminohexyl vinyl ether; and

(iv) amino group-containing polymers. These may be used singly or as combinations of two or more thereof.

(d) Carboxyl Group-Bearing Compounds:
Examples of carboxyl group-bearing compounds include

(i) saturated aliphatic monocarboxylic acids, including fatty acids and higher fatty acids, such as formic acid, acetic acid, propionic acid, isovaleric acid, hexanoic acid, lauric acid, myristic acid, palmitic acid, stearic acid, arachic acid, oleic acid, linoleic acid and linolenic acid;

(ii) saturated aliphatic dicarboxylic acids such as oxalic acid, malonic acid and succinic acid;

(iii) organic carboxylic acids having an ester group, such as 2-acryloyloxyethylsuccinic acid and 3-acryloyloxypropylphthalic acid;

(iv) carbocyclic carboxylic acids such as benzoic acid, toluic acid and salicylic acid;

(v) heterocyclic carboxylic acids such as furancarboxylic acid, thiophenecarboxylic acid and pyridinecarboxylic acid;

(vi) unsaturated mono- or dicarboxylic acids or unsaturated dibasic acids, such as acrylic acid, methacrylic acid, crotonic acid, itaconic acid, maleic acid, fumaric acid, monobutyl itaconate and monobutyl maleate;

(vii) carboxylic acid-derived acid anhydrides, such as acetic anhydride, succinic anhydride and phthalic anhydride; and

(viii) polymeric carboxylic acids such as polyacrylic acid and polymethacrylic acid. These may be used singly or as combinations of two or more thereof.

(e) Isocyanate Group-Bearing Compounds:
Examples of isocyanate group-bearing compounds include

(i) isocyanate compounds such as cyclohexyl isocyanate, n-decyl isocyanate, n-undecyl isocyanate, n-dodecyl isocyanate, n-tridecyl isocyanate, n-tetradecyl isocyanate, n-pentadecyl isocyanate, n-hexadecyl isocyanate, n-heptadecyl isocyanate, n-octadecyl isocyanate, n-eicosyl isocyanate, phenyl isocyanate and naphthyl isocyanate; and

(ii) isocyanate compounds having two or more isocyanate groups of the type used in carbodiimide compounds.

(f) Epoxy Group-Bearing Compounds
Example of epoxy group-bearing compounds include

(i) glycidyl ethers of aliphatic polyols, such as neopentyl glycol diglycidyl ether, 1,6-hexanediol diglycidyl ether, ethylene glycol diglycidyl ether, propylene glycol diglycidyl ether, hexamethylene glycol diglycidyl ether, cyclohexanediol diglycidyl ether, glycerol triglycidyl ether, trimethylolpropane triglycidyl ether and pentaerythritol tetraglycidyl ether;

(ii) glycidyl ethers of polyalkylene glycols, such as polyethylene glycol diglycidyl ether, polypropylene glycol diglycidyl ether and polytetramethylene glycol diglycidyl ether;

(iii) polyester resin-based polyglycidyl compounds;

(iv) polyamide resin-based polyglycidyl compounds;

(v) bisphenol A-based epoxy resins;

(vi) phenol-novolak-based epoxy resins;

(vii) epoxyurethane resins; and

(viii) epoxy group-containing monomers such as glycidyl (meth)acrylate, (β-methyl)glycidyl (meth)acrylate, 3,4-epoxycyclohexyl (meth)acrylate, allyl glycidyl ether, 3,4-epoxyvinylcyclohexane, di(β-methyl)glycidyl maleate

and di(β-methyl)glycidyl fumarate.

Use can be made of commercial epoxy group-containing compounds, examples of which include the following Denacol series products: Denacol EX-611, -612, -614, -614B, -622, -512, -521, -411, -421, -313, -314, -321, -201, -211, -212, -252, -810, -811, -850, -851, -821, -830, -832, -841, -861, -911, -941, -920, -931, -721, -111, -212L, -214L, -216L, -321L, -850L, -1310, -1410, -1610 and -610U (all products of Nagase ChemteX Corporation).

Alternatively, a water-soluble carbodiimide compound may be used to reduce the impact on the environment. Examples of water-soluble carbodiimide compounds include those having hydrophilic segments at the ends of the carbodiimide compound. At least one type of residue from among those shown below may be used as the hydrophilic segment.

(g) Alkylsulfonate Residues of Formula (6) Having At Least One Reactive Hydroxyl Group

$$R^6\text{-}SO_3\text{-}R^5\text{-}OH \qquad (6)$$

In the above formula, $R^5$ is an alkylene group of from 1 to 10, and $R^6$ is an alkali metal.
Examples of alkylsulfonates include sodium hydroxyethanesulfonate and sodium hydroxypropanesulfonate. Of these, sodium hydroxypropanesulfonate is preferred.

(h) Quaternary Salts of Dialkylaminoalcohol Residues of Formula (7)

$$(R^7)_2\text{-}N\text{-}R^8\text{-}OH \qquad (7)$$

In the above formula, $R^7$ is a lower alkyl group of 1 to 4 carbons, and $R^8$ is an alkylene or oxyalkylene group of 1 to 10 carbons.
Examples of dialkylaminoalcohols include 2-dimethylaminoethanol, 2-diethylaminoethanol, 3-dimethylamino-1-propanol, 3-diethylamino-1-propanol, 3-diethylamino-2-propanol, 5-diethylamino-2-propanol and 2-(di-n-butylamino) ethanol. Of these, 2-dimethylaminoethanol is preferred.

(i) Amine Residues of Formula (8)

$$(R^7)_2\text{-}NR'\text{-}R_8\text{-}OH \qquad (8)$$

In the above formula, $R^7$ and $R^8$ are the same as in Formula (7) above, and R' is a group from a quaternizing agent. Examples of quaternizing agents include dimethylsulfuric acid and methyl p-toluenesulfonate.

(j) Alkoxy Group End-Capped Poly(Alkyleneoxide) Residues of Formula (9) Having At Least One Reactive Hydroxyl Group

$$R^9\text{-}(O\text{-}CHR^{10}\text{-}CH_2)_o\text{-}OH \qquad (9)$$

In the above formula, $R^9$ is a lower alkyl group of 1 to 4 carbons, $R^{10}$ is a hydrogen atom or a methyl group; and the letter o is an integer from 2 to 30.
Examples of poly(alkylene oxides) include poly(ethylene oxide) monomethyl ether, poly(ethylene oxide) monoethyl ether, poly(ethylene oxide-propylene oxide) monomethyl ether and poly(ethylene oxide-propylene oxide) monoethyl ether. Of these, poly(ethylene oxide) monomethyl ether is preferred.

The above-described compounds which react with an isocyanate group may be used singly or as combinations of two or more thereof.
The compounds which react with an isocyanate group are not limited to the typical compounds mentioned in (a) to (j) above. Use may also be made of other compounds (e.g., acid anhydrides) having a functional group or bonding group

which reacts with an isocyanate group.

In electronic material applications in particular, given the nature of the filler and the need for compositions obtained by adding the filler to an organic resin to have a good formability, not only must the filler have a high dispersibility in organic resins and organic solvents, it is also very important that the filler have the acid resistance required for etching treatment and that it be water-resistant so as to prevent adverse effects on such electrical characteristics as the dielectric constant, conductivity, and migration resistance. For these reasons, it is preferable for the end-capping segment to be lipophilic rather than hydrophilic, and for the compound obtained to not be water-soluble.

Preferred end-capping agents for obtaining the above compound include hydroxyl group-containing compounds such as methanol, ethanol, propanol, dodecyl alcohol and octanol; carboxyl group-containing compounds such as oxalic acid, salicylic acid, lauric acid, myristic acid, palmitic acid, stearic acid, arachic acid, oleic acid, linoleic acid and linolenic acid; isocyanate compounds such as cyclohexyl isocyanate, n-dodecyl isocyanate, n-octadecyl isocyanate, phenyl isocyanate and naphthyl isocyanate; mercapto group-containing compounds such as methanethiol, ethanethiol and propanethiol; and amino group-containing compounds such as ammonia, methylamine, ethylamine, dibutylamine, cyclohexylamine and n-dodecylamine. However, from the standpoint of dispersibility in resins and production costs, the use of dodecyl alcohol, octanol, dibutylamine, cyclohexylamine; a carboxyl group-containing compound such as lauric acid, myristic acid, palmitic acid, stearic acid, arachic acid or oleic acid; or an isocyanate compound such as phenyl isocyanate is especially preferred.

The substrate filler of the invention (referring here and below to an inorganic substance having a carbodiimide group-containing organic layer), for good dispersibility of the filler in organic solvents or organic resins, preferably satisfies the following relationship when tetrahydrofuran (THF) is used as the dispersing medium.

That is, the inorganic substance provided with the carbodiimide group-containing organic layer has a particle size distribution with a standard deviation ($A_2$) which satisfies the following relationship with respect to a standard deviation ($A_1$) of the particle size distribution for a surface-untreated inorganic substance: $(A_2)/(A_1) \leq 1.0$.

Similarly, for good dispersibility of the filler in an organic solvent or organic resin, the substrate filler of the invention preferably satisfies the following relationship when THF is used as the dispersing medium.

That is, the inorganic substance provided with the carbodiimide group-containing organic layer has a volume mean particle diameter ($M_2$) which satisfies the following relationship with respect to a volume mean particle diameter ($M_1$) of a surface-untreated inorganic substance: $(M_2)/(M_1) \leq 1.0$.

In addition, for reasons having to do with the lipophilicity of the filler, the dispersibility of the filler in an organic resin when molding a substrate, and the physical properties after molding, it is preferable for the substrate filler of the invention to satisfy the following relationship when water having a pH of 7 is used as the dispersing medium.

That is, the inorganic substance provided with the carbodiimide group-containing organic layer has a particle size distribution with a standard deviation ($A_4$) which satisfies the following relationship with respect to a standard deviation ($A_3$) of the particle size distribution for a surface-untreated inorganic substance: $(A_4)/(A_3) > 1.0$.

For such reasons as good dispersibility in an organic resin when molding a substrate and good physical properties after molding, it is even more preferable for $(A_4)/(A_3) > 1.5$, and most preferable for $(A_4)/(A_3) > 1.8$.

Similarly, for reasons having to do with the lipophilicity of the filler, the dispersibility of the filler in an organic resin when molding a substrate, and the physical properties after molding, it is preferable for the substrate filler of the invention to satisfy the following relationship when water having a pH of 7 is used as the dispersing medium.

That is, the inorganic substance provided with the carbodiimide group-containing organic layer has a volume mean particle diameter ($M_4$) which satisfies the following relationship with respect to a volume mean particle diameter ($M_3$) of a surface-untreated inorganic substance: $(M_4)/(M_3) > 1.0$.

For such reasons as good dispersibility in the organic resin during molding and good physical properties after molding, it is even more preferable for $(M_4)/(M_3) > 1.2$, and most preferable for $(M_4)/(M_3) > 1.5$.

In addition, for good lipophilicity of the filler, it is preferable for the substrate filler of the invention to satisfy the following formula when water having a pH of 7 is used as the dispersing medium.

That is, the inorganic substance having a carbodiimide group-containing organic layer thereon has a zeta potential ($z_2$) which satisfies the following relationship with respect to the zeta potential ($Z_1$) of the surface-untreated inorganic substance: $|(Z_1|/|(Z_2)| > 1.0$.

The volume mean particle diameter above is a value measured with a laser diffraction/scattering-type or dynamic light scattering-type particle size analyzer. More specifically, the volume mean particle diameter is a value measured using a specimen having a concentration capable of being measured with the particle size analyzer to be used, which specimen has been prepared by adding the inorganic substance to and dispersing it in THF or pH 7 water.

Here, the standard deviation, which is a measure of the width in the distribution of the measured particle size, is the value calculated by the following formula.

$$\text{Standard deviation} = (d84\% - d16\%)/2$$

where

d84%: volume mean particle diameter (μm) at 84% of cumulative curve

d16%: volume mean particle diameter (μm) at 16% of cumulative curve

The zeta potential is a value measured with a Zetasizer Nano (manufactured by Sysmex Corporation) after adding the inorganic substance to pH 7 water in a proportion of 0.1 wt% and inducing dispersion for 15 minutes with an ultrasonic dispersing unit.
As used herein, "surface-untreated inorganic substance" refers to an inorganic substance which does not have a carbodiimide group-containing organic layer and has not been subjected to any other surface modification (i.e., which has not been treated with a surface treatment agent). The inorganic substance making up the surface-untreated inorganic substance and the inorganic substance making up the inorganic substance having a carbodiimide group-containing organic layer thereon are identical.

A method for preparing the substrate filler of the invention is described below.
The carbodiimide group-containing organic layer in the invention may be a layer composed only of a carbodiimide group-containing compound or a layer obtained by providing carbodiimide groups to a layer composed of an organic compound which contains no carbodiimide groups.
As used herein, "a layer obtained by providing carbodiimide groups to a layer composed of an organic compound which contains no carbodiimide groups" refers to a layer obtained by grafting a carbodiimide group-containing compound onto an organic layer which contains no carbodiimide groups, or to a copolymer layer composed of an organic compound having no carbodiimide groups and a carbodiimide group-containing compound.

In the practice of the invention, the formation of an organic layer composed of the above carbodiimide group-containing compound on a surface of the inorganic substance may involve directly or indirectly bonding a functional group, a surface charge or an ionic component present on the inorganic substance itself with the carbodiimide group-containing compound via a chemical bond such as a covalent bond, hydrogen bond, coordinate bond or ionic bond.
The reaction between the inorganic substance and the carbodiimide group-containing compound may be suitably selected from among known techniques depending on the type of bond. Illustrative examples include methods in which first the compound of above formula (I), (1) or (2) or the (co)polymer containing recurring units of formula (3) or (4) is prepared by polymerization, following which these are chemically bonded to a surface of an inorganic substance. Examples of chemical bonds between the surface of the inorganic substance and the carbodiimide group-containing compound include covalent bonds, hydrogen bonds and coordinate bonds.
The bonding reaction between the inorganic substance and the carbodiimide group-containing compound may be, for example, a dehydration reaction, a substitution reaction, an addition reaction, an adsorption reaction or a condensation reaction. Covalent bonds are especially preferred because they create strong bonds between the inorganic substance and the organic component.

In cases where the organic layer is formed using functional groups present on the inorganic substance itself, the surface of the inorganic substance may first be modified with a reactive functional group-containing compound. By means of such surface modification, the bonds between the inorganic substance and the carbodiimide group-containing organic layer can be made stronger.
Illustrative examples of such reactive functional groups include hydroxyl groups, amino groups (preferably primary or secondary), carboxyl groups, thiol groups, isocyanate groups, epoxy groups, urethane bonds, urea bonds, amide bonds, acid anhydrides, and polymerizable double bonds.

Any of various known methods may be employed as the method of modifying the inorganic substance with a compound bearing such a reactive functional group, although it is convenient to use a method which involves treatment with a surface treatment agent that is appropriate for the functional group to be introduced.
Surface treatment agents include, but are not limited to, unsaturated fatty acids such as oleic acid; unsaturated fatty acid metal salts such as sodium oleate, calcium oleate and potassium oleate; unsaturated fatty acid esters; unsaturated fatty acid ethers; surfactants; silane coupling agents such as vinyltrimethoxysilane, 3-aminopropyltriethoxysilane, 3-glycidoxypropyltrimethoxysilane, methacryloxymethyltrimethoxysilane, methacryloxypropyltrimethoxysilane, 3-mercaptopropyltrimethoxysilane and 3-chloropropyltrimethoxsilane; and titanate coupling agents such as titanium acylates and titanium alcoholates.
In some cases, the carbodiimide group-containing compounds of formulas (1) and (2) may have a reactivity similar to that of a silane coupling agent or a titanate coupling agent. The advantage in such cases is that a carbodiimide group-containing organic layer may be efficiently formed on the surface of the inorganic substance without surface treating the inorganic substance.

Another way to form an organic layer composed of the above carbodiimide group-containing compound on the inorganic substance surface involves carrying out a polymerization reaction at the surface of the inorganic substance so as to form a (co)polymer layer. Illustrative, non-limiting, examples of such techniques include the following.

(a) A process in which (co)polymerization of a starting monomer that provides carbodiimide group-containing recurring units of formulas (3) and/or (4) (and, if necessary, a monomer that provides recurring units of formula (5)) is carried out at the inorganic substance surface, thereby chemically bonding the (co)polymer to the inorganic substance surface, and the (co)polymer chains are extended so as to form a carbodiimide group-containing organic layer.

(b) A process in which (co)polymerization of a monomer without carbodiimide groups is carried out at the inorganic substance surface so as to chemically bond the (co)polymer and the inorganic substance, following which the groups on the (co)polymer which are capable of reacting with isocyanate groups or carbodiimide groups are reacted with the isocyanate groups or carbodiimide groups on a carbodiimide group-containing organic compound, thereby forming a carbodiimide group-containing organic layer having structural units of formulas (3) and (4).

In process (a), first a monomer having a group capable of reacting with an isocyanate group or a carbodiimide group and having also a polymerizable functional group is reacted with, for example, a carbodiimide group-containing compound of formula (I), thereby forming a starting monomer which provides recurring units of formulas (3) and/or (4). Next, this starting monomer (and, if necessary, a starting monomer which provides recurring units of formula (5)) is (co) polymerized at the surface of the inorganic substance. This (co)polymer is chemically bonded to the inorganic substance surface, in addition to which the carbodiimide group-containing compound chains are extended, thereby forming a carbodiimide group-containing organic layer (commonly referred to as a "grafting from" technique).

In process (b), first a monomer having a group capable of reacting with an isocyanate group or a carbodiimide group and having also a polymerizable functional group is (co)polymerized at the surface of the inorganic substance and thereby chemically bonded to the inorganic substance surface, in addition to which the polymer chains are extended, thereby forming a carbodiimide group-containing organic layer. Next, the groups present on the organic compound layer which are capable of reacting with an isocyanate group or a carbodiimide group are reacted with, for example, a carbodiimide compound of formula (I), thereby forming a carbodiimide group-containing organic layer (commonly referred to as a "grafting from" technique).

The (co)polymerization method is exemplified by addition polymerization, polycondensation, hydrogen transfer polymerization and addition condensation.

Examples of addition polymerization include radical polymerization, ionic polymerization, oxidative anionic polymerization and ring-opening polymerization. Examples of polycondensation include elimination polymerization, dehydrogenation polymerization and denitrogenation polymerization. Examples of hydrogen transfer polymerization include polyaddition, isomerization polymerization and group transfer polymerization.

Radical polymerization is especially preferred because it is simple and very cost-effective, and is commonly used for the industrial synthesis of various polymers. Living radical polymerization, while not yet widely used in industry, is especially useful in that it facilitates control of the molecular weight, molecular weight distribution and grafting density of the polymer.

The polymerization conditions are not subject to any particular limitation. Various known conditions may be employed according to such factors as the monomer being used.

For example, when grafting is effected by carrying out radical polymerization at the surface of the inorganic substance, the amount of monomer having functional groups capable of reacting therewith per 0.1 mol of reactive functional groups present on or introduced onto the inorganic substance is generally from 1 to 300 moles, and the amount of polymerization initiator used is generally from 0.005 to 30 moles. The polymerization temperature is generally from -20 to 1,000°C, and the polymerization time is generally from 0.2 to 72 hours.

If necessary, various additives such as dispersants, stabilizers and emulsifiers (surfactants) may be added to the polymerization reaction system at the time that polymerization is carried out.

Initiators that may be used in radical polymerization are not subject to any particular limitation, and may be suitably selected from among known radical polymerization initiators. Examples include, but are not limited to, peroxide such as benzoyl peroxide, cumene hydroperoxide, t-butyl hydroperoxide, sodium persulfate, potassium persulfate and ammonium persulfate; and azo compounds such as azobisisobutyronitrile, azobismethylbutyronitrile and azobisisovaleronitrile. These may be used singly or as combinations of two or more thereof.

The solvent used in polymerization is not subject to any particular limitation. Use may be made of any common solvent hitherto used in polymer synthesis.

Specific examples include, but are not limited to, ketones such as acetone, methyl ethyl ketone, methyl isobutyl ketone

and cyclohexanone; esters such as ethyl acetate, butyl acetate, ethyl propionate and cellosolve acetate; aliphatic or aromatic hydrocarbons such as pentane, 2-methylbutane, n-hexane, cyclohexane, 2-methylpentane, 2,2-dimethylbutane, 2,3-dimethylbutane, heptane, n-octane, isooctane, 2,2,3-trimethylpentane, decane, nonane, cyclopentane, methylcyclopentane, methylcyclohexane, ethylcyclohexane, p-menthane, dicyclohexyl, benzene, toluene, xylene, ethylbenzene and anisole (methoxybenzene); halogenated hydrocarbons such as carbon tetrachloride, trichloroethylene, chlorobenzene and tetrabromoethane; ethers such as ethyl ether, dimethyl ether, trioxane and tetrahydrofuran; and acetals such as methylal and diethylacetal. These may be used singly or as combinations of two or more thereof.
In the invention, an ionic liquid may be used as the reaction solvent. Using an ionic liquid makes it possible to shorten the production time, in addition to which the amount of organic solvent used can be held to zero or a very low level. Moreover, because ionic liquids are reusable, they can increase the environmental compatibility and safety. In addition, by carrying out the above-described polymerization reaction in an ionic liquid, the thickness of the carbodiimide group-containing organic layer may be further increased, enabling a substrate filler having even better dispersibility in organic resins to be obtained.
As used herein, "ionic liquid" refers generically to liquid salts, and particularly salts which become liquid at or near room temperature. These are solvents composed entirely of ions.
The ionic liquid used in the invention, while not subject to any particular limitation, is preferably one in which the cations making up the ionic liquid are of at least one type selected from among ammonium cations, imidazolium cations and pyridinium cations. Of these, ammonium cations are especially preferred.
Imidazolium cations are exemplified by, but not limited to, dialkylimidazolium cations and trialkylimidazolium cations. Specific examples include the 1-ethyl-3-methylimidazolium ion, 1-butyl-3-methylimidazolium ion, 1,2,3-trimethylimidazolium ion,
1,2-dimethyl-3-ethylimidazolium ion, 1,2-dimethyl-3-propylimidazolium ion and 1-butyl-2,3-dimethylimidazolium ion.
Examples of pyridinium cations include, but are not limited to, the N-propylpyridinium ion, N-butylpyridinium ion, 1-butyl-4-methylpyridinium ion and 1-butyl-2,4-dimethylpyridinium ion.
Ammonium cations are exemplified by, but not limited to, those in which an aliphatic or an alicyclic quaternary ammonium ion serves as the cation component.
Illustrative, non-limiting, examples of such aliphatic or alicyclic quaternary ammonium ions include such quaternary alkylammonium ions as the trimethylpropylammonium ion, trimethylhexylammonium ion, tetrapentylammonium ion, diethylmethyl(2-methoxyethyl)ammonium ion and diethylmethyl(2-methoxyethyl)ammonium ion; and also the N-butyl-N-methylpyrrolidinium ion and the N-(2-methoxyethyl)-N-methylpyrrolidinium ion.
The anion making up the above-described ionic liquid includes, but is not limited to, $BF_4^-$, $PF_6^-$, $AsF_b^-$, $SbF_b^-$, $AlCl_4^-$, $HSO_4^-$, $ClO_4^-$, $CH_3SO_3^-$, $CF_3SO_3^-$, $CF_3CO_2^-$, $(CF_3SO_2)_2N^-$, $Cl^-$, $Br^-$ and $I^-$.
Preferred examples of the ionic liquid include, but are not limited to,
the bis(trifluoromethanesulfonimide) salt of diethylmethyl(2-methoxyethyl)ammonium,
the (tetrafluoroborate) salt of diethylmethyl(2-methoxyethyl)ammonium and
the bis(trifluoromethanesulfonyl)imide salt of N-(2-methoxyethyl)-N-methylpyrrolidinium.
In the practice of the invention, the ionic liquid may be used alone or it may be used in admixture with any of various conventionally used solvents such as those mentioned above as polymerization reaction solvents.
When the ionic liquid is used in admixture with a conventional solvent, mixture may be carried out in any amount. However, to ensure the simplicity of subsequent treatment, environmental compatibility and safety, it is desirable for the concentration of ionic liquid in the mixed solvent to be at least 10 wt%, preferably at least 50 wt%, and more preferably from 80 to 100 wt%.
Still further methods of forming an organic layer composed of the carbodiimide group-containing compound on an inorganic substance surface include a process in which the above-described organic isocyanate compound is copolymerized on the surface of the inorganic substance in the presence of a catalyst which promotes the conversion of an isocyanate to a carbodiimide, thereby forming a carbodiimide group-containing organic layer; and a process in which the above-described organic isocyanate compound is polymerized on an inorganic substance surface covered with an organic compound layer having groups capable of reacting with isocyanate groups or carbodiimide groups but lacking carbodiimide groups, and in the presence of a catalyst which promotes the conversion of isocyanate to carbodiimide, thereby forming a carbodiimide group-containing organic layer.
In the substrate filler of the invention, the carbodiimide group-containing organic layer is present in an amount of preferably at least 0.1 wt%, based on the inorganic substance. In particular, taking into consideration the dispersibility of the substrate filler in organic resins and the electrical and mechanical characteristics of substrates thereby obtained, the amount of the carbodiimide group-containing organic layer is more preferably at least 0.3 wt%, even more preferably at least 0.5 wt%, and most preferably at least 1.0 wt%.
The weight percent (wt%) of the carbodiimide group-containing organic layer is a calculated value obtained after first determining the respective volumes of the organic layer and the inorganic substance per cubic centimeter of the substrate filler from density measurements taken with a gas pycnometer (Accupyc 1330, manufactured by Shimadzu Corporation;

in helium).

The thickness of the carbodiimide group-containing organic layer is not subject to any particular limitation. However, taking into consideration the dispersibility of the substrate filler in organic resins and the electrical and mechanical characteristics of substrates thereby obtained, although the thickness depends on such factors as the particle size, the type of carbodiimide resin and the surface area of coverage and therefore cannot be strictly specified, at a microscopic level it is preferably on average at least 1 nm, more preferably at least 2 nm, and even more preferably at least 3 nm. The thickness of the carbodiimide group-containing organic layer is a calculated value obtained after first determining the volume of the organic layer, the volume of the inorganic substance and the total surface area per cubic centimeter of the substrate filler from density measurements taken with a gas pycnometer (Accupyc 1330, manufactured by Shimadzu Corporation; in helium). In the calculations, the substrate filler is assumed to be in the form of spherical particles.

Examples of the organic resin in the inventive composition for use as an inorganic/organic composite substrate-forming material include, but are not limited to, thermoplastic resins such as polyolefin resins (e.g., polyethylene, polypropylene), polystyrene resins (e.g., polystyrene), polyvinyl halide derivative resins (e.g., polyvinyl chloride, polyvinylidene chloride), polyvinyl acetate derivative resins (e.g., polyvinyl acetate), poly(meth)acrylate resins (e.g., polymethyl methacrylate), polyvinyl ethers (e.g., polyvinyl methyl ether, polyvinyl ethyl ether, polyvinyl isobutyl ether), polyvinyl ketones (e.g., polyvinyl methyl ketone, polyvinyl hexyl ketone, polymethyl isopropenyl ketone), poly(N-vinyl) compounds (e.g., poly(N-vinylpyrrole), poly(N-vinylcarbazole), poly(N-vinylindole), poly(N-vinylpyrrolidone)), fluorocarbon resins, polyamides (e.g., nylon 6), polyesters, polycarbonates, silicones, polyacetals and acetyl cellulose; and thermoset resins such as epoxy resins, phenolic resins, urea resins, melamine resins, alkyd resins and unsaturated polyester resins.

Of these, from the standpoint of such considerations as environmental compatibility, it is preferable to use polystyrene resins, polyolefin resins, poly(meth)acrylate resins, vinyl carboxylate resins such as polyvinyl acetate, and epoxy resins.

No particular limitation is imposed on the proportions in which the substrate filler and the organic resin are compounded. However, to achieve a good balance between the various functionality-improving effects and the decline in physical properties which result from incorporation of the substrate filler, the weight ratio of the substrate filler (untreated inorganic substance basis) to the organic resin is preferably from 5:95 to 90:10, more preferably from 10:90 to 80:20, and even more preferably from 15:85 to 85:15.

The composition may be prepared by using any suitable method to mix together the substrate filler and the organic resin. At the time of mixture, use may also be made of a solvent.

Examples of the solvent that may be used when preparing the composition include, but are not limited to, ketones such as acetone, methyl ethyl ketone, methyl isobutyl ketone and cyclohexanone; esters such as ethyl acetate, butyl acetate, ethyl propionate and cellosolve acetate; aliphatic or aromatic hydrocarbons such as pentane, 2-methylbutane, n-hexane, cyclohexane, 2-methylpentane, 2,2-dimethylbutane, 2,3-dimethylbutane, heptane, n-octane, isooctane, 2,2,3-trimethylpentane, decane, nonane, cyclopentane, methylcylopentane, methylcyclohexane, ethylcyclohexane, p-menthane, benzene, toluene, xylene and ethylbenzene; halogenated hydrocarbons such as carbon tetrachloride, trichloroethylene, chlorobenzene and tetrabromoethane; ethers such as ethyl ether, dimethyl ether, trioxane and tetrahydrofuran; acetals such as methylal and diethylacetal; and sulfur or nitrogen-containing organic compounds such as nitropropene, nitrobenzene, pyridine, dimethylformamide and dimethylsulfoxide. Based on such considerations as the solubility, moldability and molding efficiency of the organic resin, the use of a ketone, such as acetone, methyl ethyl ketone, methyl isobutyl ketone or cyclohexanone, or of toluene or tetrahydrofuran is most preferred. These may be used singly or as combinations of two or more thereof.

In the inventive composition, the substrate filler in one gram of the composition has a total surface area of preferably from 2,000 to 1,000,000 $cm^2$, more preferably from 4,000 to 600,000 $cm^2$, and even more preferably from 10,000 to 500,000 $cm^2$. For reasons having to do with the moldability and physical properties of the composition, the total surface area of the substrate filler in one gram of the composition is most preferably from 13,000 to 300,000 $cm^2$. As used herein, "total surface area" refers to a theoretical value obtained by arithmetically adding up the surface area for all of the substrate filler added to the organic resin. In determining the surface area, it is assumed that the substrate filler is in the form of spherical particles. The particle size refers to the volume mean particle diameter.

The substrate filler of the invention has an excellent dispersibility in organic resins and organic solvents. Moreover, because, even at high loadings in an organic resin, the substrate filler does not invite declines in the electrical characteristics, mechanical characteristics, heat resistance and water absorptivity of molded substrates obtained therefrom, it can be included within the composition in a high proportion of 15 wt% or more that provides a total covered surface area of 2,000 $cm^2$ (per gram of composition) or more.

It is also preferable for the inventive composition for use as an inorganic/organic composite substrate-forming material to have a low coefficient of expansion. Moreover, the composition preferably has characteristics (1) to (6) below. In (1) to (3) below, the organic resin used in both compositions is the same. Also, the term 'composition' as used in the present invention encompasses not only compositions of indefinite state obtained by merely mixing the substrate filler

and the organic resin, but also shaped materials obtained by shaping such compositions.

(1) The composition for use as an inorganic/organic composite substrate-forming material has a dielectric constant which satisfies the following relationship with respect to the dielectric constant of an untreated inorganic substance-containing composition that includes, instead of the substrate filler in the inorganic/organic composite substrate-forming material composition, a like amount (inorganic substance basis) of an inorganic substance lacking an organic layer: (dielectric constant of composition for use as an inorganic/organic composite substrate-forming material)/(dielectric constant of untreated inorganic substance-containing composition) < 1.0, and preferably < 0.99.

If this dielectric constant ratio is 1.0 or more, the carbodiimide group-containing organic layer formed on the surface of the inorganic substance will have an insufficient dielectric constant increase-preventing effect.

The dielectric constant is measured at a frequency of 1 GHz using a dielectric constant measuring instrument (4291B Impedance Material Analyzer, manufactured by Agilent Technologies).

(2) The composition for use as an inorganic/organic composite substrate-forming material has an elastic modulus which satisfies the following relationship with respect to the elastic modulus of an untreated inorganic substance-containing composition that includes, instead of the substrate filler in the composition for use as an inorganic/organic composite substrate-forming material, a like amount (inorganic substance basis) of an inorganic substance lacking an organic layer: (elastic modulus of composition for use as an inorganic/organic composite substrate-forming material)/(elastic modulus of untreated inorganic substance-containing composition) > 1.10, and preferably > 1.20.

At an elastic modulus ratio of 1.10 or less, molded substrates obtained by molding the composition may have a lower mechanical strength. This is presumably a result of poor dispersibility of the substrate filler in the organic resin.

The elastic modulus is measured at room temperature using a thermal analysis/rheology system (EXTAR 600, manufactured by Seiko Instrument).

(3) The composition for use as an inorganic/organic composite substrate-forming material has a bending stress which satisfies the following relationship with respect to the bending stress of an untreated inorganic substance-containing composition that includes, instead of the substrate filler in the composition for use as an inorganic/organic composite substrate-forming material, a like amount (inorganic substance basis) of an inorganic substance lacking an organic layer: (bending stress of composition for use as an inorganic/organic composite substrate-forming material)/(bending stress of untreated inorganic substance-containing composition) > 1.0, and preferably > 1.1.

At a bending stress ratio of 1.0 or less, molded substrates obtained by molding the composition may have a lower mechanical strength. This is presumably a result of insufficient dispersibility of the substrate filler in the organic resin, and of a lower adherence between the substrate filler and the organic resin.

Although applications for the inventive substrate fillers and the inventive compositions for use as an inorganic/organic composite substrate-forming material are not subject to any particular limitation, preferred use of these can be made in materials requiring various types of functionality in such areas as electronic materials, building materials, and automotive materials.

In the area of electronic materials in particular, potential uses for the inventive fillers and compositions include printed circuit board materials, sealants, underfills and low-temperature co-fired ceramics (LTCC). These may be employed in, for example, mainframe computers, automotive electronics, information and telecommunications system equipment, substrates with built-in capacitors, cellular phones, audiovisual equipment, office automation equipment, semiconductor packages, digital broadcasting receivers, base station power amplifiers, metal substrates for automotive mounting (substrates for electrical power steering), measuring instruments, capacitors, and network equipment such as servers and routers, as well as sealants for semiconductor packages, underfill sealants, and wire coating materials.

## EXAMPLES

The invention is illustrated more fully by way of the following Synthesis Examples, Examples of the invention, and Comparative Examples. It should be noted, however, that the invention is not limited by the Examples provided below.

### [1] Synthesis of Carbodiimide Group-Containing Compounds

### Synthesis Example 1

A 300 ml three-necked flask was charged with 100 g of 1,3-bis(1-isocyanato-1-methylethyl)benzene (abbreviated below as "TMXDI"; produced by Takeda Chemical Industries, Ltd.) and 2.0 g of 1-phenyl-2-phospholene-1-oxide (abbreviated below as "p-cat") was added as the catalyst, following which the flask contents were stirred for 40 hours at 180°C under nitrogen bubbling. The resulting carbodiimide compound was diluted with 50 g of toluene (Kanto Chemical Co., Ltd.). The polycarbodiimide compound thus obtained had a degree of polymerization of about 75.

Synthesis Example 2

The polycarbodiimide compound obtained in Synthesis Example 1 was cooled to 0°C, following which 2.5 g of 3-aminopropyltriethoxysilane (a silane coupling agent produced by Chisso Corporation) was slowly added dropwise under stirring. After 12 hours of reaction at 0°C in a nitrogen atmosphere, the isocyanate group peak in the IR spectrum for the polycarbodiimide compound was confirmed to have vanished, and the reaction was stopped.

Synthesis Example 3

A 300 ml three-necked flask was charged with 100 g of 4,4'-dicyclomethane diisocyanate (abbreviated below as "HMDI"; produced by Bayer) and 0.5 g of p-cat was added as the catalyst, following which the flask contents were reacted for 10 hours at 180°C in a nitrogen atmosphere. The polycarbodiimide compound thus obtained had a degree of polymerization of about 4.

Next, 1.3 g of aminostyrene (Wako Pure Chemical Industries, Ltd.) and 2.0 g of n-dodecylamine (Wako Pure Chemical Industries) were reacted with 10.0 g of the resulting carbodiimide compound for 5 hours at 0°C in a nitrogen atmosphere.

[2] Substrate Filler (Inorganic Substance Particles Having Carbodiimide Group-Containing Organic Layer)

Example 1

Silica particles having a volume mean particle diameter of 1.0 μm (10.0 g; Admafine, produced by Admatechs Co., Ltd.) were thoroughly dispersed in 20.0 g of butyl carbitol acetate (Kanto Chemical Co., Ltd.) within a 100 ml three-necked flask. Next, 1.0 g of the compound obtained in Synthesis Example 2 was added, and the flask contents were stirred at 65°C for 15 hours. The silica particles were then washed with THF (Wako Pure Chemical Industries) and suction filtered two times to remove any Synthesis Example 2 compound which had not bonded to the silica particles. After washing, the IR spectrum of the particles was measured with an FT-IR 8900 spectrometer (Shimadzu Corporation), whereupon absorption attributable to carbodiimide groups was observed near 2,200 $cm^{-1}$, confirming that the compound obtained in Synthesis Example 2 had chemically bonded to the silica particles.

The volume mean particle diameter indicated above is a value that was measured using a particle size analyzer (MICROTRAC HRA 9320-X100, manufactured by Nikkiso Co., Ltd.).

Example 2

Silica particles having a volume mean particle diameter of 1.0 μm (10.0 g; Admafine) were thoroughly dispersed in 20.0 g of butyl carbitol acetate (Kanto Chemical) within a 100 ml three-necked flask. Next, 0.03 g of 3-aminopropyltriethoxysilane (a silane coupling agent produced by Chisso Corporation) was added and the flask contents were stirred at 65°C for 30 minutes. Subsequently, 0.5 g of 2,4-diisocyanatotoluene (abbreviated below as "TDI"; produced by Takeda Chemical Industries) was added and the flask contents were additionally stirred at 65°C for 1 hour, after which 0.02 g of p-cat and 0.12 g of n-dodecyl alcohol (Kanto Chemical) were added and the system was heated at 70°C for about 15 hours.

Following reaction completion, the silica particles were washed with THF and suction filtered four times to remove unreacted monomer and carbodiimide compound which had not chemically bonded to the silica particles. After washing, the IR spectrum of the particles was measured with an FT-IR 8900 spectrometer (Shimadzu Corporation), whereupon absorption attributable to carbodiimide groups was observed near 2,200 $cm^{-1}$, confirming that the polycarbodiimide compound had chemically bonded to the silica particles.

Example 3

Silica particles having a volume mean particle diameter of 1.0 μm (10.0 g; Admafine) were thoroughly dispersed in 20.0 g of butyl carbitol acetate within a 100 ml three-necked flask, following which 0.12 g of 3-methacryloxypropyltriethoxysilane (a silane coupling agent produced by Chisso Corporation) was added, and the reaction was carried out at 65°C for 30 minutes. Next, 7.6 g of styrene (Kanto Chemical), 0.4 g of methacrylic acid (Kanto Chemical) and 0.08 g of azobisisobutyronitrile (Kanto Chemical) as the initiator were added, and the reaction was carried out at 70°C for 15 hours.

Following reaction completion, the silica particles were washed with THF and suction filtered four times to remove unreacted monomer and polymer which had not bonded to the silica particles. After washing, the IR spectrum of the particles was measured with an FT-IR 8900 spectrometer (Shimadzu Corporation), whereupon a peak attributable to carboxylic acid was observed near 1,720 $cm^{-1}$ and absorption attributable to benzene rings was observed near 700 $cm^{-1}$, confirming that a copolymer of methacrylic acid and styrene had chemically bonded to the silica particles.

Next, 10 g of the above-prepared silica fine particles was thoroughly dispersed in 20 g of cyclohexanone (Daishin Chemicals Corporation) within a 50 ml three-necked flask, 0.3 g of TDI was added to the resulting dispersion, and the flask contents were stirred at 65°C for 1 hour. Then, 0.6 g of the catalyst p-cat and 0.12 g of n-dodecyl alcohol as an end-capping agent were added, and the reaction was carried out at 70°C for 15 hours. Following reaction completion, the silica particles were washed with THF and suction filtered four times to remove unreacted monomer. After washing, the IR spectrum of the particles was again measured, whereupon absorption attributable to carbodiimide groups on the carbodiimide compound were found to have newly appeared near 2,200 $cm^{-1}$. This confirmed that the TDI-derived carbodiimide compound had reacted with carboxyl groups in the copolymer of methacrylic acid and styrene, and was thereby grafted onto the styrene-methacrylic acid copolymer.

Example 4

Silica particles having a volume mean particle diameter of 1.0 μm (Admafine; 10.0 g) were thoroughly dispersed in 20.0 g of butyl carbitol acetate within a 100 ml three-necked flask, following which 0.12 g of 3-methacryloxypropyltriethoxysilane (a silane coupling agent produced by Chisso Corporation) was added to the resulting dispersion and the reaction was effected at 65°C for 30 minutes. Next, 7.6 g of styrene (Kanto Chemical), 4.6 g of the compound obtained in Synthesis Example 3, and 0.08 g of azobisisobutyronitrile (Kanto Chemical) as the initiator were added, and the reaction was carried out at 70°C for 15 hours.
Following reaction completion, the silica particles were washed with THF and suction filtered four times to remove polymer which had not chemically bonded to the surface of the silica particles. After washing, the IR spectrum of the particles was measured with an FT-IR 8900 spectrometer (Shimadzu Corporation), whereupon absorption attributable to carboxylic acids was observed near 1,720 $cm^{-1}$, absorption attributable to benzene rings was observed near 700 $cm^{-1}$, and absorption attributable to carbodiimide groups was observed near 2,200 $cm^{-1}$, confirming that a carbodiimide group-containing polymer layer had formed on the silica particles.

Example 5

Silica particles having a volume mean particle diameter of 1.0 μm (Admafine; 10.0 g) were thoroughly dispersed in 20.0 g of butyl carbitol acetate within a 100 ml three-necked flask, following which 1.5 g of diphenylmethane-4,4-diisocyanate (abbreviated below as "MDI"; produced by Dow Chemical Japan), 0.04 g of p-cat and 0.2 g of phenyl isocyanate (produced by Tokyo Kasei Kogyo Co., Ltd.) as an end-capping agent were added, and the system was heated at 100°C for about 3 hours.
Following reaction completion, the silica particles were washed with methyl ethyl ketone (abbreviated below as "MEK"; Sanyo Chemical Industries, Ltd.) to remove unreacted monomer and polymer which had not chemically bonded to the silica particles. After washing, the IR spectrum of the particles was measured with an FT-IR 8900 spectrometer (Shimadzu Corporation), whereupon absorption attributable to carbodiimide groups was observed near 2,200 $cm^{-1}$, confirming that a carbodiimide group-containing polymer layer had formed on the silica particles.

Example 6

Silica particles having a volume mean particle diameter of 40 nm (produced by Denki Kagaku Kogyo KK; 10.0 g) were thoroughly dispersed in 300.0 g of methyl ethyl ketone within a 500 ml three-necked flask, following which 1.5 g of MDI, 0.04 g of p-cat and 0.2 g of phenyl isocyanate (Tokyo Kasei Kogyo) as an end-capping agent were added to the dispersion and the flask contents were heated at 100°C for 3 hours.
Following reaction completion, the silica particles were washed with MEK to remove unreacted monomer and polymer which had not chemically bonded to the silica particles. After washing, the IR spectrum of the particles was measured with an FT-IR 8900 spectrometer (Shimadzu Corporation), whereupon absorption attributable to carbodiimide groups was observed near 2,200 $cm^{-1}$, confirming that a carbodiimide group-containing polymer layer had formed on the silica particles.
The volume mean particle diameter indicated above is a value that was measured using a particle size analyzer (MICROTRAC UPA 9340, manufactured by Nikkiso Co., Ltd.).

Example 7

Silica particles having a volume mean particle diameter of 40 nm (produced by Denki Kagaku Kogyo KK; 10.0 g) were thoroughly dispersed in 300.0 g of methyl ethyl ketone within a 500 ml three-necked flask, following which 1.0 g of the compound obtained in Synthesis Example 2 was added and the flask contents were stirred at 65°C for 15 hours.
Following reaction completion, the silica particles were washed with MEK to remove unreacted monomer and polymer

which had not chemically bonded to the silica particles. After washing, the IR spectrum of the particles was measured with an FT-IR 8900 spectrometer (Shimadzu Corporation), whereupon absorption attributable to carbodiimide groups was observed near 2,200 $cm^{-1}$, confirming that a carbodiimide group-containing polymer layer had formed on the silica particles.

Comparative Example 1

Silica particles having a volume mean particle diameter of 1.0 μm (Admafine; 10.0 g) were thoroughly dispersed in 20.0 g of butyl carbitol acetate within a 100 ml three-necked flask, following which 0.03 g of 3-aminopropyltriethoxysilane (a silane coupling agent produced by Chisso Corporation) was added to the resulting dispersion, and the flask contents were stirred at 65°C for 30 minutes.
Following reaction completion, the silica particles were washed with THF and suction filtered two times to remove silane coupling agent which had not bonded to the silica particles.

Comparative Example 2

Silica particles having a volume mean particle diameter of 40 nm (produced by Denki Kagaku Kogyo KK; 10.0 g) were thoroughly dispersed in 100.0 g of butyl carbitol acetate within a 100 ml three-necked flask, following which 0.03 g of glycidoxypropyltrimethoxysilane (a silane coupling agent produced by Dow Corning Toray Silicone Co., Ltd.) was added to the resulting dispersion, and the flask contents were stirred at 65°C for 30 minutes.
Following reaction completion, the silica particles were washed with THF to remove silane coupling agent which had not bonded to the silica particles.
The thickness of the surface organic layer on the silica particles obtained in Examples 1 to 7 and Comparative Examples 1 and 2, and the weight-average molecular weight (Mw) of the polymer which formed the surface organic layer, were determined as described below. The results are presented together in Table 1.

[Method of Measuring the Weight-Average Molecular Weight]

The weight-average molecular weight was measured by gel filtration chromatography (GPC) using the following apparatus and conditions.

Molecular Weight Measurement Conditions

| | |
|---|---|
| GPC apparatus: | C-R7A, manufactured by Shimadzu Corporation |
| Detector: | UV spectrophotometer detector (SPD-6A), manufactured by Shimadzu Corporation |
| Pump: | Molecular weight distribution measurement system pump (LC-6AD), manufactured by Shimadzu Corporation |
| Columns: | A total of three columns connected in series; two Shodex KF804L (Showa Denko K.K.) columns and one Shodex KF806 (Showa Denko) |
| Solvent: | Tetrahydrofuran |
| Measurement temperature: | 40°C |

[Method of Measuring Thickness of Polymer Layer]

The densities of the respective silica particles in Examples 1 to 7 and Comparative Examples 1 and 2 were determined using a gas pycnometer (Accupyc 1330, manufactured by Shimadzu Corporation; in helium). Based on these results and the densities of the silica particles prior to reaction, the volume of the polymer layer, the volume of the inorganic substance, and the total surface area per cubic centimeter ($cm^3$) of the inorganic substance having a polymer layer thereon were determined. The thickness of the polymer layer was calculated from these values. The volumes and total surface area were determined by assuming the silica particles at this time to be truly spherical.
Table 1

| | Thickness (nm) | Average molecular weight (Mw) |
|---|---|---|
| Example 1 | 9.0 | 16,000 |
| Example 2 | 3.5 | 830 |
| Example 3 | 5.2 | 15,000 |
| Example 4 | 5.2 | 13,000 |
| Example 5 | 3.5 | 1,200 |
| Example 6 | 0.30 | 1,000 |
| Example 7 | 0.72 | 16,000 |
| Comparative Example 1 | 0* | -- |
| Comparative Example 2 | 0* | -- |
| Note: In Table 1, "0*" signifies that, based on calculations, the thickness was substantially 0 nm. | | |

[Dispersibility Test: Viscosity]

Each of the following was respectively dispersed in 4.50 g of toluene (Kanto Chemical): 4.61 g of the silica particles prepared in Example 1, 4.56 g of the silica particles prepared in Example 2, 4.57 g of the silica particles prepared in Example 3, 4.57 g of the silica particles prepared in Example 4, 4.56 g of the silica particles prepared in Example 5, 4.50 g of the silica particles prepared in Comparative Example 1, and 4.50 g of untreated silica particles (Admafine; Comparative Example 3). Also, 0.11 g of the compound obtained in Synthesis Example 1, which is the same amount as the carbodiimide resin that was bonded to the silica particles in Example 1, was added respectively to 4.50 g of untreated silica particles (Admafine) and 4.50 g of the silica prepared in Comparative Example 1, and each of these was likewise dispersed in 4.50 g of toluene (Comparative Examples 4 and 5).
In addition, 4.66 g of the silica particles prepared in Example 6, 4.72 g of the silica particles prepared in Example 7, 4.5 g of the silica particles prepared in Comparative Example 2, and 4.5 g of untreated silica particles (Comparative Example 6) were respectively dispersed in 10 g of MEK. The amount of silica particles added in the respective examples of the invention and comparative examples were set so that, as with the above-described method of calculation, the amount of virgin silica particles included in each case was the same.
The viscosities of these samples at 30°C were measured with a Brookfield DV-III digital rheometer.
Table 2

| | Viscosity | |
|---|---|---|
| | Measured value (mPa·s) | Rating |
| Example 1 | 1.81 | Excellent |
| Example 2 | 2.50 | Excellent |
| Example 3 | 2.55 | Excellent |
| Example 4 | 2.80 | Excellent |
| Example 5 | 2.50 | Excellent |
| Example 6 | 43.51 | Good |
| Example 7 | 54.65 | Good |
| Comparative Example 1 | 150.00 | Fair |
| Comparative Example 2 | 71.00 | Fair |
| Comparative Example 3 | 370,000.00 | NG |
| Comparative Example 4 | 365,000.00 | NG |

(continued)

| | Viscosity | |
|---|---|---|
| | Measured value (mPa·s) | Rating |
| Comparative Example 5 | 155.00 | Fair |
| Comparative Example 6 | 3,000.00 | NG |

Excellent: The viscosity was low and affinity with the organic solvent was high in Examples 1 to 5 with respect to Comparative Example 3, and in Examples 6 and 7 with respect to Comparative Example 6.

Good: The viscosity was somewhat low and affinity with the organic solvent was somewhat high in Examples 1 to 5 with respect to Comparative Example 3, and in Examples 6 and 7 with respect to Comparative Example 6.

Fair: The viscosity was somewhat high and affinity with the organic solvent was somewhat low in Examples 1 to 5 with respect to Comparative Example 3, and in Examples 6 and 7 with respect to Comparative Example 6.

NG: The viscosity was quite high and affinity with the organic solvent was quite low in Examples 1 to 5 with respect to Comparative Example 3, and in Examples 6 and 7 with respect to Comparative Example 6.

It can be seen from the results shown in Table 2 that the silica particles obtained in Examples 1 to 7 have an excellent dispersibility in toluene or MEK. In particular, it is apparent from the results of Example 1 and Comparative Example 4 that, even when the same amount of carbodiimide group-containing organic substance is included with respect to the silica particles, if the carbodiimide group-containing organic substance is not chemically bonded to the surface of the inorganic substance, the dispersibility in toluene is markedly diminished.

[Dispersibility Test: Particle Size Distribution]

Specimens were prepared by dispersing the silica particles of Examples 1 to 7 and Comparative Examples 1, 2, 3 and 6 in THF or pH 7 water. The volume mean particle diameters and standard deviations were determined using these specimens.
More specifically, first the silica particles obtained in above Examples 1 to 7 and in Comparative Examples 1, 2, 3 and 6 were added to THF or to water having a pH of 7 in respective amounts of 10 wt%, and dispersed therein for 30 minutes with an ultrasonic dispersing unit (Ultra Turrax T18, manufactured by Nissei Corporation).
Next, the volume mean particle diameter was measured using a particle size analyzer (MICROTRAC HRA 9320-X100 (measurement range, 0.7 μm to 700 μm) or MICROTRAC UPA 9340 (measurement range, 3.2 nm to 6.54 μm), both manufactured by Nikkiso Co., Ltd.). Measurements were carried out with the MICROTRAC HRA 9320-X100 in Examples 1 to 5 and Comparative Examples 1 and 3, and with the MICROTRAC UPA 9340 in Examples 6 and 7 and Comparative Examples 2 and 6. The volume mean particle diameters and standard deviations are shown in Table 3.
In addition, the values obtained when the particle size (M2) and standard deviation (A2) in THF and the particle size (M4) and standard deviation (A4) in water for Examples 1 to 5 are divided by, respectively, the particle size (M1) and standard deviation (A1) in THF and the particle size (M3) and standard deviation (A3) in water for Comparative Example 3; and the values obtained when the particle size (M2) and standard deviation (A2) in THF and the particle size (M4) and standard deviation (A4) in water for Examples 6 and 7 are divided by, respectively, the particle size (M1) and standard deviation (A1) in THF and the particle size (M3) and standard deviation (A3) in water for Comparative Example 6 are also shown in Table 3.
The standard deviation, which is a measure of the width in the distribution of the measured particle size, is the value calculated by the following formula.

$$\text{Standard deviation} = (d84\% - d16\%)/2$$

where

d84%: volume mean particle diameter (μm) at 84% of cumulative curve
d16%: volume mean particle diameter (μm) at 16% of cumulative curve

Table 3

| | THF | | | | Water | | | |
|---|---|---|---|---|---|---|---|---|
| | Volume mean particle diameter (μm) | Standard deviation | (M2)/ / (M1) | (A2)/ (A1) | Volume mean particle diameter (μm) | Standard deviation | (M4)/ / (M3) | (A4)/ (A3) |
| Example 1 | 0.94 | 0.40 | 0.13 | 0.68 | 19.1 | 8.98 | 21.95 | 24.94 |
| Example 2 | 1.05 | 0.45 | 0.14 | 0.76 | 2.05 | 0.83 | 2.36 | 2.31 |
| Example 3 | 0.98 | 0.43 | 0.13 | 0.73 | 20.0 | 9.05 | 22.99 | 25.13 |
| Example 4 | 1.03 | 0.45 | 0.14 | 0.76 | 19.0 | 8.90 | 21.84 | 24.72 |
| Example 5 | 0.87 | 0.38 | 0.12 | 0.64 | 1.80 | 0.78 | 2.06 | 2.17 |
| Example 6 | 0.05 | 0.03 | 0.36 | 0.60 | 0.92 | 0.81 | 7.08 | 5.78 |
| Example 7 | 0.05 | 0.03 | 0.36 | 0.60 | 2.86 | 1.18 | 22.00 | 8.43 |
| Comparative Example 1 | 2.10 | 0.50 | -- | -- | 1.50 | 0.40 | -- | -- |
| Comparative Example 2 | 0.10 | 0.05 | -- | -- | 0.50 | 0.85 | -- | -- |
| Comparative Example 3 | 7.31 | 0.59 | -- | -- | 0.87 | 0.36 | -- | -- |
| Comparative Example 6 | 0.14 | 0.05 | -- | -- | 0.13 | 0.14 | -- | -- |

Aside from adding the silica particles of Examples 1 to 7 and Comparative Examples 1, 2, 3 and 6 to THF in an amount of 30 wt%, the same operations were carried out. The volume mean particle diameters and standard deviations were measured, in addition to which the following volume mean particle diameter ratio was determined. Those results are presented in Table 4.

**Volume mean particle diameter ratio (30) = (volume mean particle diameter when 30 wt% is added) /(volume mean particle diameter when 10 wt% is added)**

Table 4

| | THF | | |
|---|---|---|---|
| | Volume mean particle diameter (μm) | Standard deviation | Volume mean particle diameter ratio (30) |
| Example 1 | 0.95 | 0.40 | 1.01 |
| Example 2 | 1.06 | 0.45 | 1.01 |
| Example 3 | 0.99 | 0.43 | 1.01 |
| Example 4 | 1.04 | 0.45 | 1.01 |
| Example 5 | 0.88 | 0.38 | 1.01 |

(continued)

| | THF | | |
|---|---|---|---|
| | Volume mean particle diameter (μm) | Standard deviation | Volume mean particle diameter ratio (30) |
| Example 6 | 0.051 | 0.03 | 1.02 |
| Example 7 | 0.051 | 0.03 | 1.02 |
| Comparative Example 1 | 2.50 | 0.8 | 1.20 |
| Comparative Example 2 | 0.30 | 1.0 | 3.00 |
| Comparative Example 3 | 9.50 | 1.0 | 1.30 |
| Comparative Example 6 | 446 | 241 | 3185 |

Aside from adding the particles of Examples 1 to 7 and Comparative Examples 1, 2, 3 and 6 to THF in an amount of 50 wt%, the same operations were carried out. The volume mean particle diameters and standard deviations were measured, in addition to which the following volume mean particle diameter ratio was determined. Those results are presented in Table 5.

Volume mean particle diameter ratio (50) = (volume mean particle diameter when 50 wt% is added) /(volume mean particle diameter when 10 wt% is added)

Table 5

| | THF | | |
|---|---|---|---|
| | Volume mean particle diameter (μm) | Standard deviation | Volume mean particle diameter ratio (50) |
| Example 1 | 0.96 | 0.45 | 1.02 |
| Example 2 | 1.07 | 0.50 | 1.02 |
| Example 3 | 1.00 | 0.50 | 1.02 |
| Example 4 | 1.05 | 0.49 | 1.02 |
| Example 5 | 0.89 | 0.40 | 1.02 |
| Example 6 | 0.053 | 0.04 | 1.06 |
| Example 7 | 0.053 | 0.04 | 1.06 |
| Comparative Example 1 | 3.50 | 1.5 | 1.67 |
| Comparative Example 2 | 400 | 200 | 4000 |
| Comparative Example 3 | 19.48 | 15.8 | 2.66 |
| Comparative Example 6 | not measurable | -- | -- |
| Not measurable: The particles agglomerated, making measurement impossible. | | | |

Aside from adding the particles of Examples 1 to 7 and Comparative Examples 1, 2, 3 and 6 to THF in an amount of 60 wt%, the same operations were carried out. The volume mean particle diameters and standard deviations were measured, in addition to which the following volume mean particle diameter ratio was determined. Those results are presented in Table 6.

$$\text{Volume mean particle diameter ratio (60)} = (\text{volume mean particle diameter when 60 wt\% is added}) / (\text{volume mean particle diameter when 10 wt\% is added})$$

Table 6

| | THF | | |
|---|---|---|---|
| | Volume mean particle diameter (μm) | Standard deviation | Volume mean particle diameter ratio (60) |
| Example 1 | 0.97 | 0.42 | 1.03 |
| Example 2 | 1.08 | 0.48 | 1.02 |
| Example 3 | 1.00 | 0.45 | 1.02 |
| Example 4 | 1.06 | 0.45 | 1.03 |
| Example 5 | 0.90 | 0.38 | 1.03 |
| Example 6 | 0.060 | 0.04 | 1.20 |
| Example 7 | 0.060 | 0.04 | 1.20 |
| Comparative Example 1 | 20.0 | 15.0 | 9.52 |
| Comparative Example 2 | not measurable | -- | -- |
| Comparative Example 3 | 159 | 114 | 21.75 |
| Comparative Example 6 | not measurable | -- | -- |
| Not measurable: The particles agglomerated, making measurement impossible. | | | |

As shown in Tables 4 to 6 above, when THF is used as the dispersing medium, the above-described dispersion properties, such as volume mean particle diameter and standard deviation, can be achieved with the addition of the inventive substrate filler in an amount of not only 10 wt%, but also 30 wt%, 50 wt%, and even 60 wt% or more.
Moreover, trends similar to those for THF were obtained using MEK and toluene (Sanyo Chemical Industries) as the dispersing medium, even when the substrate filler was added in amounts of 30 wt%, 50 wt%, or 60 wt% or more.
Highly loaded dispersions can thus be obtained in which increases in viscosity and agglomeration are suppressed and a highly dispersed state is achieved. Hence, higher loadings in organic resins at the time of substrate molding are possible, and further improvements can be made in moldability and in the physical properties after molding. These too are major features of the present invention.

[Dispersibility Test: Zeta Potential]

The silica particles in Examples 1 to 7 and Comparative Examples 1 to 6 were added to pH 7 water in an amount of 0.1 wt% and dispersed therein for 15 minutes with an ultrasonic dispersing unit, following which measurements were carried out with a Zetasizer Nano (manufactured by Sysmex Corporation). The results are shown in Table 7.
Table 7

| | Zeta Potential |
|---|---|
| Example 1 | 14 |
| Example 2 | 20 |
| Example 3 | 23 |
| Example 4 | 22 |

(continued)

| | Zeta Potential |
|---|---|
| Example 5 | 25 |
| Example 6 | 27 |
| Example 7 | 23 |
| Comparative Example 1 | 30 |
| Comparative Example 2 | 32 |
| Comparative Example 3 | 36 |
| Comparative Example 4 | 36 |
| Comparative Example 5 | 30 |
| Comparative Example 6 | 36 |

[3] Preparation of Compositions for Inorganic/Organic Composite Substrate-Forming Materials (Molded Bodies)

Examples 8 to 14, and Comparative Examples 7 to 12

In the respective examples, a dispersion obtained by dispersing 4.61 g of the silica particles prepared in Example 1 (Example 8), 4.56 g of the silica particles prepared in Example 2 (Example 9), 4.57 g of the silica particles prepared in Example 3 (Example 10), 4.57 g of the silica particles prepared in Example 4 (Example 11), 4.56 g of the silica particles prepared in Example 5 (Example 12), 4.50 g of the silica particles prepared in Comparative Example 1 (Comparative Example 7) or 4.50 g of untreated silica particles (Comparative Example 8) in 4 g of THF was added to a mixture composed of 3.60 g of epoxy resin (Epiclon N-740, produced by Dainippon Ink & Chemicals, Inc.) and 0.90 g of a curing agent (Novacure HX3722, produced by Asahi Kasei Corporation), thereby giving compositions for inorganic/organic composite substrate-forming materials. In addition, 0.11 g of the carbodiimide compound obtained in Synthesis Example 1 (which is the same amount as the Synthesis Example 1 carbodiimide resin that was bonded to the silica particles in Example 1) was added to, respectively, 4.50 g of untreated silica particles and 4.50 g of the silica particles prepared in Comparative Example 1, and compositions were prepared in the same way as in Example 8 (Comparative Examples 9 and 10).
Additional compositions were prepared by adding, respectively, 1.38 g of the silica particles prepared in Example 6 (Example 13), 1.42 g of the silica particles prepared in Example 7 (Example 14), 1.35 g of the silica particles prepared in Comparative Example 2 (Comparative Example 11) or 1.35 g of untreated silica particles (Comparative Example 12) to 3.5 g of THF, then adding the resulting dispersions to a mixture composed of 3.60 g of epoxy resin (Epiclon N-740, produced by Dainippon Ink & Chemicals, Inc.) and 0.40 g of a curing agent (Novacure HX3722, produced by Asahi Kasei Corporation).
Here, the amounts of silica particles added in the respective examples of the invention and comparative examples and the amounts of polycarbodiimide compound added in Comparative Examples 9 and 10 were set, based on the method of calculation described below, so that the amounts of virgin silica particles included in each composition are the same.

Method of Calculation

The densities of 5 g of, respectively, the silicas synthesized in Examples 1 to 7 and untreated silica particles were measured with a gas pycnometer (Accupyc 1330, manufactured by Shimadzu Corporation; in helium). The results were 2.62 g/cm$^3$ for both untreated silica particles and the silica that was surface-treated in Example 1.
Here, because the carbodiimide compound obtained in Synthesis Example 2 has a density of 1.07 g/cm$^3$ and untreated silica has a density of 2.26 g/cm$^3$, letting the volume of the carbodiimide compound obtained in Synthesis Example 1 that serves as the surface layer per cubic centimeter of the treated silica be X cm$^3$, we get the following:

$$1.07X + 2.26(1-X) = 2.20.$$

Thus, X is 0.051 cm$^3$.
Therefore, the weight of the carbodiimide compound obtained in Synthesis Example 2 per cubic centimeter (cm$^3$) of the treated silica is 0.051 cm$^3$ x 1.07 g/cm$^3$ = 0.054 g, and the weight of untreated silica (Admafine) is (1 - 0.051)

$cm^3$ x 2.26 g/$cm^3$ = 2.14 g.
Hence, the amount of the polymer layer on the silica particles prepared above, as a proportion of the treated silica, is given by

$$(100 \times 0.054\ g)/(2.14 + 0.054\ g) = 2.46\ wt\%.$$

From the above, the amounts of silica present in 4.50 g of untreated silica and in 4.61 g of the silica particles having a carbodiimide group-containing organic layer of Example 1 are equivalent.
The amounts of silica and polymer in the silica particles obtained in Examples 2 to 7 were also calculated in the same way. The respective amounts of polymer were found to be 1.25 wt% in Example 2, 1.52 wt% in Example 3, 1.52 wt% in Example 4, 1.25 wt% in Example 5, 2.50 wt% in Example 6, and 4.92 wt% in Example 7.

The compositions prepared in above Examples 8 to 14 and Comparative Examples 7 to 12 were formed into films by bar coating. The resulting films were dried overnight, then cured by 1 hour of heat treatment at 100°C followed by 0.5 hour of heat treatment at 170°C. The properties described below were rated for each of the cured films thus obtained. The results are shown in Tables 8 and 9. The cured films obtained from each of these compositions were formed to two thicknesses of about 150 μm and about 600 μm. The following physical properties were measured and rated for each of these cured films.

[Formability and Physical Properties of Compositions (Shaped Articles)]

(1) Formability Test

Aside from the dimensions of the test specimens, the above cured films (150 μm) were evaluated based on the following criteria in accordance with the method described in JIS K 7104.

Good: The silica particles were very uniformly loaded, and the cured film had a smooth surface (as determined by touch and sight).
Fair: The silica particles were uniformly loaded, but the surface of the cured film was uneven in places.
NG: The silica particles were not uniformly loaded, and the entire surface of the cured film was uneven.

(2) Mechanical Strength Test

The elastic modulus of the cured film (150 μm) was measured at room temperature using a thermal diffraction/rheology system (EXTAR 600; Seiko Instrument). The test pieces used had the following dimensions: a width of 0.4 cm and a length of 2.0 cm.

Good: The elastic modulus improved substantially over that in Comparative Example 7 (Examples 8 to 12, Comparative Examples 8 to 10).
The elastic modulus improved substantially over that in Comparative Example 11 (Examples 13 and 14, Comparative Example 12).
Fair: The elastic modulus improved slightly over that in Comparative Example 7 (Comparative Examples 8 to 12, Comparative Examples 8 to 10).
The elastic modulus improved slightly over that in Comparative Example 11 (Comparative Examples 13 and 14, Comparative Example 12).
NG: The elastic modulus decreased.

(3) Dielectric Constant Test

The dielectric constant of the cured film (150 μm) was measured at room temperature and a frequency of 1 GHz using a dielectric constant measuring instrument (4291B Impedance Material Analyzer, manufactured by Agilent Technologies). The compositions containing untreated silica had a poor formability and a variable dielectric constant. Hence, the average of the values measured at four places was used as the dielectric constant.

Good: The dielectric constant decreased relative to that in Comparative Example 7 (Examples 8 to 12, Comparative Examples 8 to 10).
The dielectric constant decreased relative to that in Comparative Example 11 (Examples 13 and 14, Comparative Example 12).

NG: The dielectric constant did not decrease.

(4) Bending Test

The cured film (600 μm) was cut to a width of 100 mm and a length of 4 cm, and the maximum point flexural stress was measured with a three-point bending tester (Microforce Tester, manufactured by Instron Corporation). The measurement conditions were a support span of 10 mm, an initial load of 5 g, and a bending speed of 10 mm/min.

Good: The flexural stress was significantly higher than in Comparative Example 7 (Examples 8 to 12, Comparative Examples 8 to 10).

The flexural stress was significant higher than in Comparative Example 11 (Examples 13 and 14, Comparative Example 12).

Fair: The flexural stress was slightly higher than in Comparative Example 7 (Examples 8 to 12, Comparative Examples 8 to 10).

The flexural stress was slightly higher than in Comparative Example 11 (Examples 13 and 14, Comparative Example 12).

NG: The flexural stress either did not increase, or it decreased.

Table 8

| | Formability | Elastic modulus | | | Dielectric constant | | | Three-point bending test | | |
|---|---|---|---|---|---|---|---|---|---|---|
| | | Measured value ($10^9$ Pa) | Elastic modulus ratio | Rating | Measured value | Dielectric constant ratio | Rating | Measured value ($kgf/cm^2$) | Stress ratio | Rating |
| Example 8 | good | 1.79 | 1.59 | good | 3.17 | 0.97 | good | 769 | 1.28 | good |
| Example 9 | good | 1.65 | 1.47 | good | 3.18 | 0.98 | good | 800 | 1.33 | good |
| Example 10 | good | 1.38 | 1.23 | good | 3.18 | 0.98 | good | 790 | 1.32 | good |
| Example 11 | good | 1.40 | 1.25 | good | 3.19 | 0.98 | good | 780 | 1.30 | good |
| Example 12 | good | 1.80 | 1.61 | good | 3.17 | 0.97 | good | 950 | 1.58 | good |
| Example 13 | good | 1.75 | 1.94 | good | 3.50 | 0.97 | good | 1500 | 1.33 | good |
| Example 14 | good | 1.65 | 1.83 | good | 3.51 | 0.97 | good | 1300 | 1.15 | good |
| Comparative Example 7 | fair | 1.12 | -- | -- | 3.24 | -- | NG | 600 | -- | -- |
| Comparative Example 8 | NG | 1.10 | 0.98 | NG | 3.24 | 1 | NG | 551 | 0.92 | NG |
| Comparative Example 9 | NG | 1.15 | 1.05 | fair | 3.24 | 1 | NG | 555 | 0.93 | NG |
| Comparative Example 10 | fair | 1.17 | 1.06 | fair | 3.24 | 1 | NG | 605 | 1.01 | fair |
| Comparative Example 11 | fair | 0.90 | -- | -- | 3.60 | -- | NG | 1130 | -- | -- |
| Comparative Example 12 | NG | 0.85 | 0.94 | NG | 3.60 | 1 | NG | 1100 | 0.97 | NG |

The ratios of the various physical property ratio values shown in Table 8 were calculated relative to data from Comparative Example 7 in the case of Examples 8 to 12 and Comparative Examples 8 to 10, and relative to data from Comparative Example 11 in the case of Examples 13 and 14 and Comparative Example 12; that is, with the Comparative Example 7 data or the Comparative Example 11 data serving as the denominator.
It is apparent from Table 8 that the inorganic/organic composite substrate-forming compositions of Examples 8 to 14 in which the silica particles having a carbodiimide group-containing organic layer that were obtained in Examples 1 to 7 above serve as fillers exhibited good values with respect to both their moldability and physical properties.
By contrast, from the results obtained for Example 8 and Comparative Examples 9 and 10, it is evident that, even when the same amount of carbodiimide group-containing organic substance is present in the composition, the moldability and physical property-enhancing effects are modest at best if the carbodiimide group-containing organic substance is not bonded to the surface of the inorganic substance.

(5) Insulation Resistance Test

To determine the insulation reliability of the above-described cured films (150 μm), the insulation resistance (MΩ) values under normal conditions (96 hours of treatment in constant-temperature, constant-humidity air at 20°C and 65% RH) and following boiling water treatment (2 hours of immersion in constant-temperature, boiling water at 100°C) were measured using an insulation resistivity tester (HP 4339B High Resistance Meter, manufactured by Hewlett Packard Japan KK).
Measurement conditions: voltage, 100 V (AC voltage); current, 500 μA

Good: Insulation resistance value decreased less than 5%.
Fair: Insulation resistance value decreased 5% or more but less than 10%.
NG: Insulation resistance value decreased 10% or more.

(6) Heat Resistance Test

Heat resistance tests were conducted on the above-described cured films (150 μm). The percent weight loss when a cured film was held at 288°C for 30 minutes was measured using a TG/DTA Autosampler AST-2 (manufactured by Seiko Instrument).

Good: Percent weight loss was lower than in Comparative Example 8 (Examples 8 to 12, Comparative Examples 7, 9, 10).
Percent weight loss was lower than in Comparative Example 12 (Examples 13 and 14, Comparative Example 1).
Fair: Percent weight loss was less than 1 wt% greater than in Comparative Example 8 (Examples 8 to 12, Comparative Examples 7, 9, 10).
Percent weight loss was less than 3 wt% greater than in Comparative Example 12 (Examples 13 and 14, Comparative Example 1).

The weight losses here are values obtained by subtracting the weight loss for the above-described cured film from the weight loss for a composition in which the inorganic substance has not been added.

(7) Water Absorption Test

The above-described cured films (thickness, 600 μm) were cut to a width of 50 mm and a length of 100 mm, and the resulting test pieces were left for 24 hours in a high-temperature chamber held at 50°C. The test pieces were then cooled to 20°C in a desiccator and weighed.
The test pieces were subsequently immersed for 24 hours in a vessel containing 23°C distilled water, following which they were removed from the vessel and the moisture was wiped off with a dry cloth. The weight of the test piece following water absorption was measured within a period of one minute.

Good: Percent weight gain was less than in Comparative Example 7 (Examples 8 to 12, Comparative Examples 8 to 10).
Percent weight gain was less than in Comparative Example 11 (Examples 13 and 14, Comparative Example 12).
NG: Percent weight gain was the same as or more than in Comparative Example 7 (Examples 8 to 12, Comparative Examples 8 to 10).

Percent weight gain was the same as or more than in Comparative Example 11 (Examples 13 and 14, Comparative

Example 12).

Table 9

| | Insulation reliability | Heat Resistance | | Water absorption | |
|---|---|---|---|---|---|
| | | Weight loss (-%) | Rating | Weight gain (%) | Rating |
| Example 8 | good | 2.68 | good | 0.50 | good |
| Example 9 | good | 1.12 | good | 0.58 | good |
| Example 10 | good | 2.50 | good | 0.56 | good |
| Example 11 | good | 2.30 | good | 0.52 | good |
| Example 12 | good | 1.12 | good | 0.55 | good |
| Example 13 | good | 2.74 | good | 1.49 | good |
| Example 14 | good | 2.90 | good | 1.50 | good |
| Comparative Example 7 | fair | 2.71 | fair | 0.70 | -- |
| Comparative Example 8 | NG | 2.69 | -- | 0.80 | NG |
| Comparative Example 9 | NG | 2.69 | good | 0.80 | NG |
| Comparative Example 10 | fair | 2.71 | fair | 0.70 | NG |
| Comparative Example 11 | fair | 2.93 | fair | 2.10 | -- |
| Comparative Example 12 | NG | 2.95 | -- | 2.30 | NG |

It is apparent from the data presented in Table 9 that the inorganic/organic composite substrate-forming compositions of Examples 8 to 14 in which the silica particles having a carbodiimide group-containing organic layer obtained in Examples 1 to 7 are included as fillers have an improved water resistance because the inorganic substance is covered with a carbodiimide resin. It is also evident that, because the carbodiimide group-containing organic substance on the surface is strongly bonded with the resin, moisture-trapping voids do not readily form, thus enhancing the dielectric reliability. In addition, it is also obvious from the data that the carbodiimide group-containing organic substance on the surface of the inorganic substance does not have an adverse influence on the heat resistance.

Based on the above results, inorganic substances having a carbodiimide group-containing organic layer possess a high dispersibility in organic resins and organic solvents, enabling the decreases in physical properties that have been a problem in the prior art to be avoided. Accordingly, high fillings in resin can be achieved while preventing declines in the physical properties. These fillers are expected to see use in a variety of applications.

## Claims

1. A filler for substrates, **characterized by** comprising an inorganic substance and a carbodiimide group-containing organic layer that is chemically bonded to a surface of the inorganic substance.

2. The substrate filler of claim 1 wherein, when tetrahydrofuran is used as a dispersing medium, the inorganic substance having said carbodiimide group-containing organic layer has a particle size distribution with a standard deviation ($A_2$) which satisfies the following relationship with respect to a standard deviation ($A_1$) of the particle size distribution for a surface-untreated inorganic substance:

$$(A_2)/(A_1) \leq 1.0.$$

3. The substrate filler of claim 1 wherein, when tetrahydrofuran is used as a dispersing medium, the inorganic substance having said carbodiimide group-containing organic layer has a volume mean particle diameter ($M_2$) which satisfies the following relationship with respect to a volume mean particle diameter ($M_1$) of a surface-untreated inorganic

substance:

$$(M_2)/(M_1) \leq 1.0.$$

4. The substrate filler of claim 1 wherein, when pH 7 water is used as a dispersing medium, the inorganic substance having said carbodiimide group-containing organic layer has a particle size distribution with a standard deviation ($A_4$) which satisfies the following relationship with respect to a standard deviation ($A_3$) of the particle size distribution for a surface-untreated inorganic substance:

$$(A_4)/(A_3) > 1.0.$$

5. The substrate filler of claim 1 wherein, when pH 7 water is used as a dispersing medium, the inorganic substance having said carbodiimide group-containing organic layer has a volume mean particle diameter ($M_4$) which satisfies the following relationship with respect to a volume mean particle diameter ($M_3$) of a surface-untreated inorganic substance:

$$(M_4)/(M_3) > 1.0.$$

6. The substrate filler of claim 1, wherein said carbodiimide group-containing organic layer is at least one compound selected from among carbodiimide group-containing compounds of formula (1) below and carbodiimide group-containing compounds of formula (2) below:

$$(X^1)_m\text{-}Z\text{-}[A\text{-}(R^1\text{-}N{=}C{=}N)_n\text{-}R^1\text{-}NCO]_1 \quad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_1 \quad (2)$$

wherein
$R^1$ is a residue from an isocyanate compound;
$X^1$ and $X^2$ are each independently a hydrogen atom, a halogen atom, an alkyl group of 1 to 20 carbons which may include an unsaturated structure, an aryl group of 6 to 20 carbons, an aralkyl group of 7 to 20 carbons or an alkoxy group of 1 to 20 carbons, and $X^1$ and $X^2$ in each instance, if plural, may be the same or different;
each Z is independently a silicon atom or a titanium atom;
A is an organic group which has a valence of 2 or more and includes a bond derived from an isocyanate group;
the letters m and 1 are integers from 1 to 3 which satisfy the condition m+1 = 4; and
the letter n is an integer from 1 to 100.

7. The substrate filler of claim 6, wherein at least one terminal isocyanate group on the carbodiimide group-containing compound of formula (1) is capped with a functional group which is reactive with isocyanate groups.

8. The substrate filler of claim 7, wherein said functional group which is reactive with isocyanate groups is a hydroxyl group, a primary or secondary amino group, a carboxyl group or a thiol group.

9. The substrate filler of any one of claims 1 to 8, wherein the carbodiimide group-containing organic layer is lipophilic.

10. The substrate filler of any one of claims 1 to 9, wherein the inorganic substance is composed of particles having a volume mean particle diameter of from 1 nm to 100 μm.

11. A composition for use as an inorganic/organic composite substrate-forming material which is **characterized by** comprising the substrate filler of any one of claims 1 to 10 and an organic resin.

**12.** The composition for use as an inorganic/organic composite substrate-forming material of claim 11, wherein the substrate filler is included in an amount of at least 15 wt%, based on the organic resin.

**13.** The composition for use as an inorganic/organic composite substrate-forming material of claim 11 or 12, wherein the substrate filler included in 1 g of the composition has a total surface area of at least 2,000 $cm^2$.

**INTERNATIONAL SEARCH REPORT**

International application No.
PCT/JP2006/312400

A. CLASSIFICATION OF SUBJECT MATTER
*C08K9/04*(2006.01), *C08L101/00*(2006.01), *H05K1/03*(2006.01)

According to International Patent Classification (IPC) or to both national classification and IPC

B. FIELDS SEARCHED

Minimum documentation searched (classification system followed by classification symbols)
C08L23/00-101/16, C08K3/00-13/08, H05K1/03

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,A | JP 2005-281644 A (Catalysts & Chemicals Industries Co., Ltd.), 13 October, 2005 (13.10.05), Claims (Family: none) | 1-13 |
| X<br>A | JP 9-290482 A (Tsutsunaka Plastic Industry Co., Ltd.), 11 November, 1997 (11.11.97), Full text (Family: none) | 1,11,12<br>2-10,13 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 July, 2006 (05.07.06) | 18 July, 2006 (18.07.06) |
| Name and mailing address of the ISA/ Japanese Patent Office | Authorized officer |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5230279 A
- JP 61275359 A
- JP 63258958 A
- JP 51061599 A
- JP 2292316 A


### Non-patent literature cited in the description


- **L.M. ALBERINO et al.** *J. Appl. Polym. Sci.,* 1990, vol. 21, 190